# EUROPEAN PATENT APPLICATION

(11) **EP 4 429 424 A1**
(43) Date of publication of application: **11.09.2024**
(21) Application number: 22914605.5
(22) Date of filing: 26.12.2022
(51) Int. Cl.: H05K 7/20

(54) **CARBON MATERIAL AND USE THEREOF**

(30) Priority: 27.12.2021 CN 202111612209; 17.03.2022 CN 202210265589
(71) Applicant: Huawei Technologies Co., Ltd., Shenzhen, Guangdong 518129 (CN)
(72) Inventor: FANG, Haoming, Shenzhen, Guangdong 518129 (CN); JIN, Linfang, Shenzhen, Guangdong 518129 (CN); XU, Yan, Shenzhen, Guangdong 518129 (CN); ZHONG, Lei, Shenzhen, Guangdong 518129 (CN); HU, Jinyan, Shenzhen, Guangdong 518129 (CN); QIN, Ying, Shenzhen, Guangdong 518129 (CN); JIN, Yongfu, Shenzhen, Guangdong 518129 (CN)
(74) Representative: MERH-IP Matias Erny Reichl Hoffmann Patentanwälte PartG mbB
(86) International application number: PCT/CN2022/141764
(87) International publication number: WO 2023/125351

(57) **Abstract**

Embodiments of this application provide a carbon material and application thereof. Elongation at break of the carbon material in at least one direction is greater than or equal to 5%. In-plane thermal diffusivity of the carbon material is greater than or equal to 500 mm²/s. A surface of the carbon material has a plurality of wrinkle structures. A total length of the wrinkle structures in a unit area of 1 µm² on the surface of the carbon material is within a range of 1 µm to 500 µm. The carbon material in embodiments of this application has high elongation at break and in-plane thermal diffusivity, and has both high flexibility and good heat diffusion performance. The carbon material can be used as a heat dissipation material in a bendable electronic device, to meet a bending requirement and a heat dissipation requirement of the bendable electronic device. This application further provides a heat dissipation assembly, an electronic device, a battery system, and a semiconductor structure that include the carbon material.

## Description

This application claims priority to Chinese Patent Application No. 202111612209.X, filed with the China National Intellectual Property Administration on December 27, 2021 and entitled "CARBON MATERIAL", which is incorporated herein by reference in its entirety. This application claims priority to Chinese Patent Application No. 202210265589.2, filed with the China National Intellectual Property Administration on March 17, 2022 and entitled "CARBON MATERIAL AND APPLICATION THEREOF", which is incorporated herein by reference in its entirety.

### TECHNICAL FIELD

Embodiments of this application relate to the field of heat dissipation technologies, and in particular, to a carbon material and application thereof.

### BACKGROUND

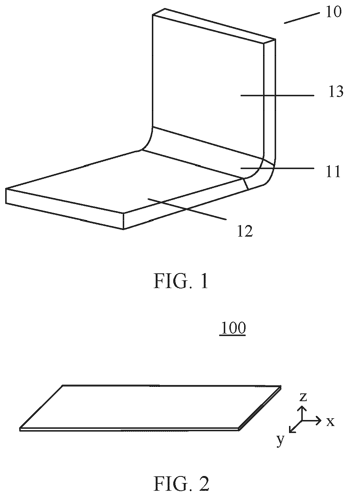

Smartphones enter an era of foldable mobile phones. A heat dissipation capability of a small foldable mobile phone is approximate to that of a bar phone. A heat dissipation capability of a large foldable mobile phone with a large heat dissipation area is far higher than that of the bar phone. However, a hinge of the foldable mobile phone is required to pass a reliability test in which bending is performed at least 100,000 times. Most conventional heat dissipation components, such as a metal heat pipe (Heat Pipe, HP), a vapor chamber (vapor chamber, VC, which is also referred to as a planar heat pipe), a non-metallic artificial graphite sheet, and a graphene heat-conductive film, cannot directly pass a reliability test in which U-shaped bending by 180 degrees is performed at least 100,000 times. In addition, as shown in FIG. 1, a hinge 11 of a foldable mobile phone 10 separates a primary screen 12 from a secondary screen 13. Main heating components such as a system on chip and a charging chip are mainly disposed on a mainboard of the primary screen 12. Due to inadequate heat dissipation capabilities of the system on chip and the charging chip, heat is concentrated on the primary screen 12 and cannot be transferred to an area of the secondary screen 13. As a result, a temperature difference between the two screens is large, which limits performance of the foldable mobile phone and affects thermal experience of a user.

### SUMMARY

In view of this, embodiments of this application provide a carbon material. The carbon material has high flexibility performance, bending performance, and heat diffusion performance, and may be used as a heat dissipation material in a bendable electronic device, to meet requirements on bending and heat dissipation of the bendable electronic device. To some extent, this resolves a difficulty in heat dissipation of a conventional bendable electronic device.

Specifically, a first aspect of embodiments of this application provides a carbon material. Elongation at break of the carbon material in at least one direction is greater than or equal to 5%. In-plane thermal diffusivity of the carbon material is greater than or equal to 500 mm²/s. A surface of the carbon material has a plurality of wrinkle structures. A total length of wrinkle structures in a unit area of 1 µm² on the surface of the carbon material is within a range of 1 µm to 500 µm.

In this embodiment of this application, the wrinkle structures are provided on the surface of the carbon material, and density of the wrinkle structures on the surface of the carbon material is adjusted and controlled, so that the elongation at break of the carbon material is improved while high heat conduction performance of the carbon material can be maintained. In this way, the carbon material has high elongation at break and in-plane thermal diffusivity, and the carbon material is bendable and has high heat diffusion performance. In this case, the carbon material can meet a bending requirement in a heat dissipation scenario. For example, the carbon material can be used in a foldable terminal device as a heat dissipation material. When used in the foldable terminal device, the carbon material may be disposed across two screens or more screens, to meet a bending reliability test requirement of the foldable terminal device, and implement heat diffusion transfer between a primary screen and a secondary screen to reduce a temperature difference between the screens. This improves performance of the foldable device and temperature experience of a user.

In this implementation of this application, the design of the wrinkle structures can effectively improve the elongation at break of the carbon material. High elongation at break makes the carbon material break-resistant and resistant to a plurality of times of bending. The plurality of wrinkle structures may be a plurality of macro wrinkle structures having millimeter-level lengths and/or a plurality of micro wrinkle structures having micron-level or submicron-level lengths. In this embodiment of this application, the entire surface of the carbon material has the wrinkle structures. Therefore, each region of the entire carbon material has good bending performance and heat dissipation performance. The carbon material does not need to be attached by region in the foldable device, so that the carbon material can be directly used in the foldable device.

In an implementation of this application, the plurality of macro wrinkle structures follow an orientation distribution on the surface of the carbon material, and the plurality of micro wrinkle structures follow an irregular distribution on the surface of the carbon material. The orientation distribution of the macro wrinkle structures on the surface of the carbon material helps improve stretchability performance of the carbon material in a direction perpendicular to an orientation distribution direction, so that a test for high bending reliability of the foldable terminal device can be passed. The irregular distribution of the micro wrinkle structures on the surface of the carbon material can improve elongation at break of the carbon material in all directions.

In an implementation of this application, average surface roughness Ra of the carbon material is greater than 100 nm. In this embodiment of this application, the carbon material has the wrinkle structures, and therefore surface roughness is high. High surface roughness helps improve the flexibility performance and bending resistance performance.

In an implementation of this application, the carbon material has a pristine film feature when a thickness is less than or equal to 5 mm. In this application, the carbon material has the pristine film feature when the thickness is less than or equal to 5 mm. In other words, bonding with an adhesive is not performed for a carbon material whose thickness is in a thickness range of 5 mm, so that the heat diffusion performance and structural stability of the carbon material can be improved, and a requirement for a large thickness in application can be met.

In an implementation of this application, the carbon material includes a plurality of stacked carbon atom layers, and in the carbon material, a turbostratic stack proportion of the plurality of stacked carbon atom layers is greater than or equal to 10%. In the carbon material, some in the plurality of carbon atom layers are stacked in an ABA stack (Graphite carbon, G carbon) manner, the others are stacked in a turbostratic stack (Turbostratic carbon, Ts carbon) manner, where turbostratic stack is ABC stack. Because the ABA stack structure has a narrower spacing between the carbon atom layers compared with the ABC stack structure, and the narrower layer spacing causes severe phonon heat dissipation between the layers, great improvement of thermal diffusivity and thermal conductivity of the material is difficult. In this embodiment of this application, a proportion of turbostratic stack structures of the carbon atom layers in the carbon material is high, and correspondingly, a proportion of the ABA stack structures is low. An increase in the proportion of the turbostratic stack structures of the carbon atom layers greatly improves in-plane thermal diffusivity of the carbon material. In this embodiment of this application, the carbon material has high thermal diffusivity, and can implement fast heat diffusion in an X-Y plane direction. The carbon material may be used, in a form of a large film, sheet, or plate, in a device having a high requirement on heat dissipation, so as to equalize heat of a heating point of the device, quickly transfer the heat of the heating point, prevent failure of the heating point, and improve security and stability of the device.

In an implementation of this application, a crystallographic L_{c} size of a crystal grain of the carbon material is greater than or equal to 50 nm. In this application, the L_{c} size of a crystal grain of the carbon material is large, and therefore the carbon material has the pristine film feature while the thickness range is large. This facilitates application of the carbon material in a scenario in which requirements on heat dissipation, heat equalization, and a film thickness are high. Using a plurality of layers of adhesives for bonding to obtain a carbon material with a large thickness can be avoided. In this way, a heat dissipation requirement of a high-power device in future 5G and 6G can be met.

In an implementation of this application, a crystallographic Lₐ size of the crystal grain of the carbon material is greater than or equal to 10 µm. In this application, the carbon material has a large single crystal Lₐ size. In this case, a large phonon free path is obtained. This improves the heat conduction performance of the carbon material, and high thermal diffusivity can be obtained.

In an implementation of this application, a C=C proportion of the carbon material is greater than or equal to 80%. A higher carbon-carbon double bond C=C proportion of the carbon material indicates higher graphitization of the carbon material, and higher graphitization facilitates obtaining of higher thermal diffusivity.

In an implementation of this application, a layer spacing between the plurality of stacked carbon atom layers is greater than or equal to 0.3 nm and less than or equal to 0.5 nm. A smaller carbon layer spacing improves the in-plane heat diffusion performance of the carbon material.

In an implementation of this application, a breaking strength of the carbon material is greater than or equal to 30 MPa. The carbon material in this embodiment of this application has a high breaking strength, indicating that the carbon material has good flexibility performance and bending performance, excels at tensile resistance, and can be used in an application scenario in which there is a bending requirement.

In an implementation of this application, the carbon material may be in a shape of a film, a sheet, a plate, or the like, and the carbon material includes a carbon film, a carbon sheet, or a carbon plate.

In an implementation of this application, the carbon material is obtained by graphitizing graphite oxide. A raw material of the graphite oxide is easy to obtain, which facilitates industrial production.

In an implementation of this application, the carbon material is obtained by graphitizing the graphite oxide. In a process of producing the carbon material by using the graphite oxide, a volatile solvent is added to a graphite oxide solution, and the volatile solvent is evaporated to form the wrinkle structures; and/or a non-graphitized carbon material precursor is repeatedly squeezed and stretched in a first axial direction and/or a second axial direction to form the wrinkle structures, where the first axial direction and the second axial direction are perpendicular to each other. In embodiments of this application, a method for rapid evaporation and drying of a volatile solvent is used to help form a plurality of randomly distributed micro wrinkle structures on a surface of a carbon material. The method for forming wrinkles is environment-friendly and fast, and toxic and harmful reduction agents, blowing agents, and the like are not used. Surface density of the formed wrinkle structures can be controlled and adjusted through control and adjustment of a type of the volatile solvent, a heating rate in evaporation, and the like. A production process is highly feasible. In this embodiment of this application, the non-graphitized carbon material precursor is repeatedly stretched and squeezed in the first axial direction and/or the second axial direction, to form a plurality of shrank macro wrinkle structures following an orientation distribution. The wrinkle formation method is easy to control, and the carbon material has high flexibility.

A second aspect of embodiments of this application provides a heat dissipation assembly, where the heat dissipation assembly includes the carbon material according to the first aspect of embodiments of this application. The carbon material in this embodiment of this application is used as a heat dissipation material, to improve the heat dissipation performance and the bending performance of the heat dissipation assembly to some extent. In this embodiment of this application, the heat dissipation assembly may include only the carbon material, or may include the carbon material and another heat dissipation material or heat dissipation element (for example, a vapor chamber or a heat dissipation film). In other words, the carbon material is used together with another heat dissipation material or heat dissipation element. The heat dissipation assembly may be configured to dissipate heat of a heating element, and transfer the heat generated by the heating element to a heat dissipation end in a timely manner, to implement heat conduction and heat equalization. The heat dissipation assembly may be used in various electronic devices that have a heat dissipation requirement, for example, may be used in an electronic device like a battery, a mobile phone, a tablet computer, a notebook computer, a watch, or a band, and in particular, may be used in a foldable electronic device, to meet both a bending requirement and a heat dissipation requirement. Specifically, the heat dissipation assembly may be disposed between circuit boards, between a circuit board and an electronic device housing, between a power component and an electronic device housing, or pasted on a chip.

In some implementations of this application, the heat dissipation assembly further includes a heat dissipation element that is attached to the surface of the carbon material or that is embedded in the carbon material.

In some implementations of this application, the heat dissipation assembly includes a base and a heat dissipation fin disposed on the base, and the carbon material is used in the base and/or the heat dissipation fin.

In an implementation of this application, the heat dissipation assembly further includes a heat pipe and/or a vapor chamber connected to the base and the heat dissipation fin.

A third aspect of embodiments of this application provides an electronic device. The electronic device includes the carbon material according to the first aspect of embodiments of this application, or includes the heat dissipation assembly according to the second aspect of embodiments of this application. The carbon material provided in the embodiment of this application is used in the electronic device for heat dissipation and heat equalization. The carbon material has good heat dissipation performance and heat equalization performance. In addition, the carbon material is flexibly disposed in the electronic device. A shape and a size of the carbon material are designed flexibly. The carbon material is easy to assemble and fix. In this way, a heat dissipation requirement of the electronic device can be met. In addition, the carbon material provided in embodiments of this application has good flexibility performance and bending performance. The carbon material can meet a cross-hinge heat dissipation requirement of a foldable electronic device, effectively equalize heat for screens, and reduce a temperature difference between the screens. The electronic device may be various electronic devices that have a heat dissipation requirement, for example, may be various devices that have a heat dissipation requirement, such as a mobile phone, a tablet computer, a notebook computer, a wearable device (like glasses, a watch, or a band), a display device, an AR device, a VR device, an AR/VR device, a television, an adapter, a router, a vehicle-mounted device, a vehicle-mounted display, a gateway, a set-top box, a charging base, a heat dissipation assembly, a battery system, a power component, and a packaging assembly. Particularly, the electronic device in this embodiment of this application may be a foldable electronic device.

In an implementation of this application, the electronic device includes a display, a middle frame, a rear cover, and a circuit board. The middle frame is configured to carry the display and the circuit board. The middle frame is located between the display and the rear cover. The carbon material is disposed between the middle frame and the rear cover and/or between the middle frame and the display. The carbon material inside the electronic device may be disposed to dissipate heat for the circuit board and the display, so that heat generated by a heating point inside the electronic device can be quickly conducted, thereby avoiding generation of the heating point inside the electronic device, and improving user experience and security stability of the electronic device.

In an implementation of this application, the electronic device further includes a two-phase liquid cooling heat dissipation member. The two-phase liquid cooling heat dissipation member is fixedly connected to a surface of the carbon material, or the two-phase liquid cooling heat dissipation member is partially or completely embedded in the carbon material. The two-phase liquid cooling heat dissipation member is used together with the carbon material, so that heat dissipation performance of the electronic device can be further improved.

In an implementation of this application, the two-phase liquid cooling heat dissipation member includes a heat pipe and/or a vapor chamber.

In an implementation of this application, the electronic device includes a bendable heating element, and the carbon material is disposed on the heating element.

An embodiment of this application further provides a battery system. The battery system includes the carbon material according to the first aspect of embodiments of this application. The carbon material in this embodiment of this application is used as a heat dissipation material, so that effective heat equalization and heat dissipation in the battery system can be implemented, generation of a heating point inside the battery system can be avoided, and security and a service life of a battery are improved.

In an implementation of this application, the battery system includes a plurality of battery packs. Each of the battery packs includes a plurality of single cells connected in series. The carbon material is disposed between the plurality of battery packs and/or between the plurality of single cells connected in series. The carbon material in this embodiment of this application is disposed between the battery packs or between the single cells, so that effective heat equalization and heat dissipation in the battery system can be implemented, generation of a heating point inside the battery system can be avoided, and security and a service life of a battery are improved.

An embodiment of this application further provides a semiconductor structure. The semiconductor structure includes a semiconductor chip and a carbon material covering the semiconductor chip. The carbon material includes the carbon material according to the first aspect of the embodiments of this application. In this embodiment of this application, the carbon material has good heat conduction performance and a low coefficient of thermal expansion. This helps reduce thermal stress inside the semiconductor chip.

### BRIEF DESCRIPTION OF DRAWINGS

FIG. 1 is a diagram of a structure of a foldable mobile phone;
FIG 2 is a diagram of a structure of a carbon material 100 according to an embodiment of this application;
FIG. 3a and FIG. 3b are photos of a surface of a carbon material 100 taken by a scanning electron microscope according to an embodiment of this application;
FIG. 4a is a diagram of carbon atom layers of a carbon material 100 that are stacked in an ABA stack manner according to an embodiment of this application;
FIG. 4b is a diagram of carbon atom layers of a carbon material 100 that are stacked in a turbostratic stack manner according to an embodiment of this application;
FIG. 5a and FIG. 5b are diagrams of sample points selected on a carbon material for parameter characterization of a carbon material 100;
FIG. 6a and FIG. 6b are diagrams of structures of a substrate selected in step S102 in an implementation;
FIG. 7a and FIG. 7b are diagrams of structures of a heat dissipation assembly 300 according to an embodiment of this application;
FIG. 8 is a diagram of a structure of an electronic device 200 according to an embodiment of this application;
FIG. 9a, FIG. 9b, and FIG. 9c are diagrams of exploded structures of an electronic device 200;
FIG. 9d and FIG. 9e are diagrams of arrangement of a carbon material, a shielding can, and a thermal interface material in an electronic device 200;
FIG. 10 is a diagram of a structure in which a carbon material 100 is fastened to a middle frame 202;
FIG. 11 is a diagram of a structure in which a heat pipe 2051 and a vapor chamber 2052 are disposed on a surface of a carbon material 100;
FIG. 12 is a diagram of a triple-screen foldable device in which a carbon material is disposed in two screens;
FIG. 13 is a diagram of a triple-screen foldable device in which a carbon material is disposed in three screens;
FIG. 14 is a diagram of a structure in which a heat dissipation assembly 300 is disposed on a heating element 24 of an electronic device 200;
FIG. 15 is a diagram of attaching a carbon material 100 to surfaces of a plurality of heating chips 24 at different heights;
FIG. 16a is a diagram of disposing a carbon material 100 outside a display assembly 30;
FIG. 16b is a diagram of disposing a carbon material 100 inside a display assembly 30;
FIG. 17 is a diagram of a structure of an electronic device 200 according to another embodiment of this application;
FIG. 18, FIG. 19, FIG. 20a, FIG. 20b, and FIG. 21 are diagrams of structures of a heat dissipation assembly 300 according to an embodiment of this application;
FIG. 22 is a diagram of disposing a carbon material 100 between battery packs 410 in a battery system 400 according to an embodiment of this application;
FIG. 23 is a diagram of disposing a carbon material 100 between single cells 411 in the battery pack 410 in FIG. 22;
FIG. 24a is a diagram of disposing a carbon material 100 in a semiconductor structure 500 in an implementation;
FIG. 24b is a diagram of disposing a carbon material 100 in a semiconductor structure 500 in another implementation;
FIG. 24c is a diagram of disposing a carbon material 100 in a semiconductor structure 500 in another implementation; and
FIG. 24d is a diagram of disposing a carbon material 100 in a semiconductor structure 500 in another implementation.

### DESCRIPTION OF EMBODIMENTS

The following describes embodiments of this application with reference to accompanying drawings in embodiments of this application.

As electronic devices become increasingly miniaturized, highly integrated, and multifunctional, there are higher requirements on heat dissipation, heat equalization, and folding of the electronic devices. To meet the requirements on heat dissipation, heat equalization, and bending reliability of the electronic device, and resolve a cross-hinge heat dissipation problem of a foldable electronic device, embodiments of this application provide a highly oriented carbon material that is resistant to a plurality of times of bending and that has high heat diffusion performance. "High orientation" in the highly oriented carbon material means that a graphite crystal structure is oriented in a specific direction, so that a carbon material in which most graphite crystals are arranged along a (100) plane can be formed. The highly oriented carbon material can facilitate obtaining of anisotropic heat conduction performance and heat dissipation performance.

Refer to FIG. 2. FIG. 2 is a diagram of a structure of a carbon material 100 according to an embodiment of this application. The carbon material 100 provided in embodiments of this application has high elongation at break and in-plane thermal diffusivity. The elongation at break of the carbon material 100 in at least one direction is greater than or equal to 5%, and the in-plane thermal diffusivity of the carbon material 100 is greater than or equal to 500 mm²/s. In addition, the carbon material 100 is resistant to a plurality of times of bending and has high heat diffusion performance.

The elongation at break is a ratio of an after-elongation length and before-elongation length after breakage of a sample on which an external force is applied, that is, a ratio of an elongated length to an initial length after breakage of the sample, which is expressed in a percentage. The elongation at break can characterize flexibility performance and elasticity performance of the carbon material. In embodiments of this application, the carbon material has high elongation at break. Therefore, the carbon material has excellent flexibility performance and stretchability performance, and can meet requirements on bending and cross-hinge heat dissipation of a foldable electronic device. In an implementation of this application, the elongation at break of the carbon material 100 in at least one direction is greater than or equal to 5%. Specifically, the elongation at break of the carbon material 100 in one direction is greater than or equal to 5%, or elongation at break of the carbon material 100 in a plurality of directions is greater than or equal to 5%. The at least one direction may be any direction in a plane direction of a surface of the carbon material 100. Refer to FIG. 2. For example, on the surface of the carbon material 100, there is an X direction and a Y direction that are perpendicular to each other, and elongation at break of the carbon material 100 in the X direction and/or the Y direction may be greater than or equal to 5%. The X direction and the Y direction may be any two directions perpendicular to each other on the surface of the carbon material 100. In some embodiments of this application, the elongation at break of the carbon material 100 in the at least one direction is 5% to 20%, and the carbon material 100 can directly pass a reliability test in which U-shaped bending by 180 degrees is performed at least 100,000 times. For bending, for example, a bending radius may be R2 mm to R5 mm. Specifically, the elongation at break of the carbon material 100 may be, for example, 5%, 5.5%, 6%, 6.5%, 7%, 7.5%, 8%, 8.5%, 9%, 9.5%, 10%, 10.5%, 11%, 12%, 13%, 14%, 15%, 16%, 17%, 18%, 19%, or 20%. In an actual application, different holes or grooves may be provided on an X-Y direction surface of the carbon material 100; or a plurality of layers of carbon materials 100 may be stacked in unequal thicknesses, so that a 2.5D structure is formed in a Z direction, or curved surface bending occurs in the Z direction. In this way, an assembly requirement or another structural design requirement can be met.

The in-plane thermal diffusivity of the carbon material 100 is thermal diffusivity of the carbon material 100 in a length-width plane direction of the carbon material 100, that is, thermal diffusivity of the carbon material 100 in an X-Y plane direction in FIG. 2. As shown in FIG. 2, the X-Y plane direction is parallel to a plane direction of a carbon atom layer, and the X-Y plane direction is perpendicular to the Z direction of the carbon material, that is, a thickness direction. The thermal diffusivity (thermal diffusivity) is a measure of a rate at which temperature disturbance of one point in an object is transferred to another point. A case in which an object is heated and a temperature rises is used as an example. In a process of unsteady-state heat transfer in heating and temperature rise of the object, heat entering the object is continuously absorbed as the heat moves along, and then a local temperature rises. This process continues until temperatures of all points inside the object are the same. A material with higher thermal diffusivity can give a human body a more obvious feeling of quick temperature transfer from one end to another end of a material. In some implementations of this application, the in-plane thermal diffusivity of the carbon material 100 is greater than or equal to 550 mm²/s. In some implementations, the in-plane thermal diffusivity of the carbon material 100 is greater than or equal to 600 mm²/s. In some implementations, the in-plane thermal diffusivity of the carbon material 100 is greater than or equal to 650 mm²/s. In some implementations, the in-plane thermal diffusivity of the carbon material 100 is greater than or equal to 700 mm²/s. In some implementations, the in-plane thermal diffusivity of the carbon material 100 is greater than or equal to 750 mm²/s. Specifically, in embodiments of this application, the in-plane thermal diffusivity of the carbon material 100 may be 500 mm²/s, 510 mm²/s, 520 mm²/s, 530 mm²/s, 540 mm²/s, 550 mm²/s, 560 mm²/s, 570 mm²/s, 580 mm²/s, 590 mm²/s, 600 mm²/s, 610 mm²/s, 620 mm²/s, 630 mm²/s, 640 mm²/s, 650 mm²/s, 660 mm²/s, 670 mm²/s, 680 mm²/s, 690 mm²/s, 700 mm²/s, 710 mm²/s, 720 mm²/s, 730 mm²/s, 740 mm²/s, 750 mm²/s, or 760 mm²/s. In embodiments of this application, the carbon material 100 has high thermal diffusivity in the X-Y plane direction, and can implement fast heat diffusion in the X-Y plane direction. The carbon material 100 may be used, in a form of a large film, sheet, or plate, in a device having a high requirement on heat dissipation, so as to equalize heat of a heating point of the device, quickly transfer the heat of the heating point, prevent failure of the heating point, and improve security and stability of the device.

In an implementation of this application, the carbon material 100 is a material having anisotropic heat conduction performance, and the thermal diffusivity of the carbon material 100 in the X-Y plane direction is greater than or equal to 500 mm²/s. The thermal diffusivity of the carbon material 100 in the Z direction, that is, the thickness direction, is very low, for example, may be 10 mm²/s or less. In some embodiments, the thermal diffusivity in the Z direction is 5 mm²/s or less, and the in-plane thermal diffusivity may be 100 times the thermal diffusivity of the Z direction. In this way, in-plane diffusion of heat can be improved, and a requirement on heat diffusion of an electronic device like a mobile phone can be met.

In an implementation of this application, the thermal diffusivity of the carbon material may be obtained through measurement with reference to GB/T 22588-2008 *Determination of thermal diffusivity of thermal conductivity by the flash method.* Specifically, the carbon material may be cut into a film with a diameter of 2 inches, and then corresponding thermal diffusivity is obtained through measurement with a laser flash apparatus.

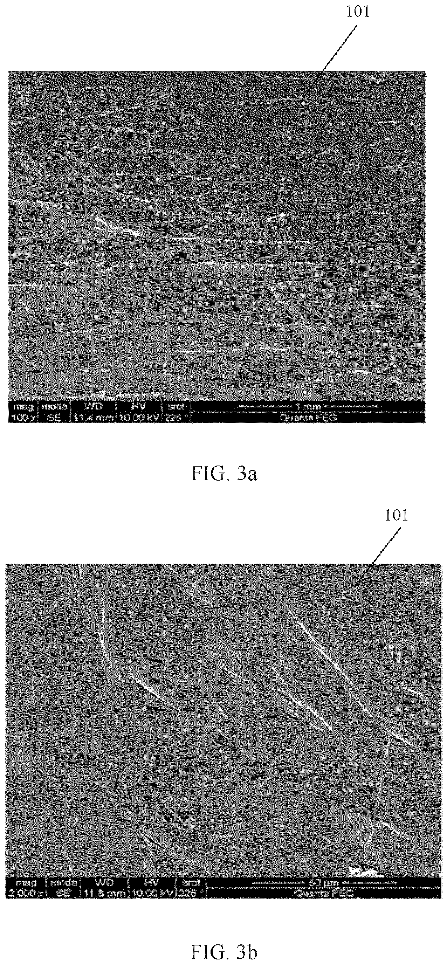

Refer to FIG. 3a and FIG. 3b. FIG. 3a and FIG. 3b are photos of the surface of the carbon material 100 taken by a scanning electron microscope. In an implementation of this application, the surface of the carbon material 100 has a plurality of wrinkle structures 101. The wrinkle structure 101 is a deformation shown when the carbon material is bent under an action of a force. When the plurality of wrinkle structures 101 are under an action of a force like stretching, bending, or torsion to some extent, the wrinkles structure are expanded. In this way, the bending performance of the carbon material is improved, and application of the carbon material to a foldable electronic device can be improved. In embodiments of this application, the entire surface (namely, a surface in the X-Y plane direction) of the carbon material 100 has the wrinkle structures 101. Therefore, each region of the entire surface of the carbon material 100 has good flexibility performance, bending performance, and heat dissipation performance. When the carbon material 100 is used in a foldable device, the carbon material 100 does not need to be attached and assembled in foldable device by region, but assembled across screens and hinges. Consequently, the carbon material can be directly assembled and used in the foldable device. In an implementation of this application, a length of the plurality of wrinkle structures 101 may be at a millimeter level, a micron level, or a submicron level. The plurality of wrinkle structures 101 may be a plurality of macro wrinkle structures having millimeter-level lengths and/or a plurality of micro wrinkle structures having micron-level or submicron-level lengths. The length of the wrinkle structure 101 is a length of the wrinkle structure in an extension direction of the wrinkle structure. The millimeter-level length may be 1 mm to 10 mm, the micron-level length may be 1 µm to 5 µm, and the submicron-level length may be greater than 100 nm and less than 1 µm. The design of the wrinkle structures can help effectively improve the elongation at break of the carbon material.

In an implementation of this application, as shown in FIG. 3 a, at least a part of or all of the plurality of macro wrinkle structures follow an orientation distribution on the surface of the carbon material 100. As shown in FIG. 3b, the plurality of micro wrinkle structures may follow an irregular distribution, namely, a random distribution, on the surface of the carbon material 100. The orientation distribution of the macro wrinkle structures on the surface of the carbon material helps improve stretchability performance of the carbon material in a direction perpendicular to an orientation distribution direction, so that a test for high bending reliability of the foldable terminal device can be passed. The irregular distribution of the micro wrinkle structures on the surface of the carbon material can help improve elongation at break of the carbon material in all directions. The plurality of macro wrinkle structures following the orientation distribution may mean that extension directions of the plurality of macro wrinkle structures are consistent or basically consistent.

In an implementation of this application, a total length of the wrinkle structures in a unit area of 1 µm² on the surface (namely, the X-Y direction surface) of the carbon material 100 falls within a range of 1 µm to 500 µm. Specifically, the total length of the wrinkle structures in an average unit area of 1 µm² on the surface of the carbon material 100 is within the range of 1 µm to 500 µm, that is, surface density of the wrinkle structures on the surface of the carbon material is within the range of 1 µm/µm² to 500 µm/µm². Through adjustment and control, the surface density of the wrinkle structures on the surface of the carbon material is within the range of 1 µm/µm² to 500 µm/µm², so that the elongation at break of the carbon material can be improved while the high heat conduction performance of the carbon material is maintained. In some embodiments of this application, the total length of the wrinkle structures in a unit area of 1 µm² on the surface of the carbon material 100 is, for example, 1 µm, 2 µm, 3 µm, 4 µm, 5 µm, 6 µm, 8 µm, 10 µm, 12 µm, 15 µm, 20 µm, 30 µm, 40 µm, 50 µm, 60 µm, 70 µm, 80 µm, 90 µm, 100 µm, 150 µm, 200 µm, 250 µm, 300 µm, 350 µm, 400 µm, 450 µm, 500 µm, or the like.

In embodiments of this application, the wrinkle structures are provided on the surface of the carbon material, and the density of the wrinkle structures on the surface of the carbon material is adjusted and controlled, so that the elongation at break of the carbon material is improved while the high heat conduction performance of the carbon material can be maintained. Consequently, the carbon material has high elongation at break and in-plane thermal diffusivity, and the carbon material is bendable and has high heat diffusion performance. In this case, the carbon material can meet a bending requirement in a heat dissipation scenario. For example, the carbon material can be used in a foldable terminal device as a heat dissipation material. When used in the foldable terminal device, the carbon material may be disposed across two screens or more screens, to meet a bending reliability test requirement of the foldable terminal device, and implement heat diffusion transfer between a primary screen and a secondary screen to reduce a temperature difference between the screens. This improves performance of the foldable device and user experience in temperature.

In an implementation of this application, average surface roughness Ra of the carbon material 100 is greater than 100 nm, that is, average surface roughness Ra of the X-Y direction surface of the carbon material 100 is greater than 100 nm. In some embodiments, the average surface roughness Ra of the carbon material is 1 µm to 5 µm. Specifically, the average surface roughness Ra of the carbon material 100 may be 500 nm, 600 nm, 800 nm, 1 µm, 1.1 µm, 1.15 µm, 2 µm, 3 µm, 4 µm, 5 µm, or the like. In embodiments of this application, the carbon material 100 has the wrinkle structures, and therefore surface roughness is high. High surface roughness helps improve the elongation at break of the carbon material, to improve bending resistance performance.

In an implementation of this application, the carbon material 100 has high cohesion, and has a pristine film feature when the thickness is less than or equal to 5 mm. In the conventional technology, to obtain a carbon material with a thickness of 2 mm or a greater thickness, a plurality of layers of carbon films are bonded by using an adhesive. Disadvantages of multi-layer bonding are that debonding is likely to occur because a structure is instable, and heat dissipation performance is lower than that of the pristine film. In this application, the carbon material has the pristine film feature when the thickness is less than or equal to 5 mm. In other words, bonding with an adhesive is not required for a carbon material whose thickness is in a thickness range of 5 mm. This can improve the heat diffusion performance and structural stability of the carbon material, and a requirement for a large thickness in application can be met. It should be noted that, in some embodiments, to meet an assembly requirement or a structural design requirement, a plurality of carbon materials 100 with thicknesses less than or equal to 5 mm may be stacked and bonded in unequal thicknesses. The carbon material with a required thickness may be produced according to a requirement. Specifically, the thickness of the carbon material may be 0.1 mm, 0.2 mm, 0.3 mm, 0.4 mm, 0.5 mm, 0.6 mm, 0.7 mm, 0.8 mm, 0.9 mm, 1.0 mm, 1.1 mm, 1.2 mm, 1.3 mm, 1.4 mm, 1.5 mm, 1.6 mm, 1.7 mm, 1.8 mm, 1.9 mm, 2 mm, 2.5 mm, 3 mm, 3.5 mm, 4 mm, 4.5 mm, 5 mm, or the like. In some embodiments, if a thicker heat-dissipation carbon material with a thickness greater than 5 mm is required, an adhesive may be used for bonding.

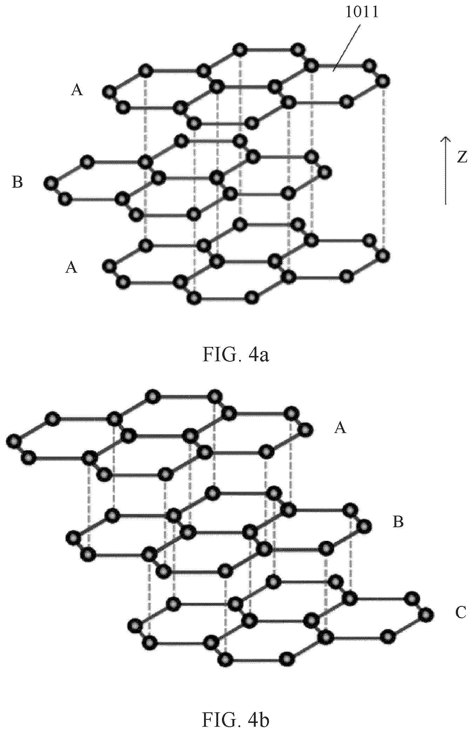

In an implementation of this application, as shown in FIG. 4a and FIG. 4b, the carbon material 100 includes a plurality of stacked carbon atom layers 1011, and the plurality of carbon atom layers 1011 are stacked in a Z direction. In the carbon material 100, some in the plurality of carbon atom layers 1011 are stacked in an ABA stack (Graphite carbon, G carbon) manner, and the others are stacked in a turbostratic stack (Turbostratic carbon, Ts carbon) manner, where turbostratic stack is ABC stack. FIG. 4a is a diagram of carbon atom layers of the carbon material 100 that are stacked in the ABA stack manner according to an embodiment of this application. FIG. 4b is a diagram of carbon atom layers of the carbon material 100 that are stacked in the turbostratic stack manner according to an embodiment of this application. For the ABA stack structure, a carbon-atom hexagon at a top layer A is precisely aligned with a carbon-atom hexagon at a bottom layer A, and a carbon-atom hexagon at a middle layer B is slightly shifted. For the ABC stack structure, a carbon-atom hexagon at each carbon atom layer is slightly shifted forward compared with that at a lower layer.

In an implementation of this application, in the carbon material 100, a turbostratic stack proportion in the plurality of stacked carbon atom layers 1011 is greater than or equal to 10%, that is, a proportion of carbon atom layers stacked in the turbostratic stack manner in the carbon material 100 is greater than or equal to 10%. The turbostratic stack proportion may be obtained by dividing a quantity of the carbon atom layers stacked in the turbostratic stack manner (Turbostratic carbon, Ts carbon) by a total of the quantity of the carbon atom layers stacked in the turbostratic stack manner (Ts carbon) and the carbon atom layers stacked in the ABA stack manner (G carbon), that is, Ts carbon/(Ts carbon+G carbon). A proportion of the Ts carbon and a proportion of the G carbon may be obtained through Raman spectra analysis, or measurement is performed according to a method of GB/T 40069-2021 *Nanotechnologies-Measurement of the number of layers of graphene-related two-dimensional (2D) materials Raman spectroscopy method,* and then the proportion of the Ts carbon is obtained based on measurement data. Specifically, Lorentzian Lorentzian fitting processing on a G signal peak of the Raman spectra may be performed.

In some implementations of this application, the turbostratic stack proportion of the carbon atom layers in the carbon material 100 is greater than or equal to 12%. In some implementations of this application, the turbostratic stack proportion of the carbon atom layers in the carbon material 100 is greater than or equal to 15%. In some implementations of this application, the turbostratic stack proportion of the carbon atom layers in the carbon material 100 is greater than or equal to 16%. In some implementations of this application, the turbostratic stack proportion of the carbon atom layers in the carbon material 100 is greater than or equal to 18%. In some implementations of this application, the turbostratic stack proportion of the carbon atom layers in the carbon material 100 is 10% to 19%. In some implementations of this application, the turbostratic stack proportion of the carbon atom layers in the carbon material 100 is greater than or equal to 20%. In some implementations of this application, the turbostratic stack proportion of the carbon atom layers in the carbon material 100 is greater than or equal to 21%. In other implementations, the turbostratic stack proportion of the carbon atom layers in the carbon material 100 is greater than or equal to 22%. In some other implementations, the turbostratic stack proportion of the carbon atom layers in the carbon material 100 is greater than or equal to 25%. In some embodiments of this application, the turbostratic stack proportion of the carbon atom layers in the carbon material 100 is 20% to 25%. Because the ABA stack structure has a narrower layer spacing, and the narrower layer spacing causes severe phonon heat dissipation between graphite layers, great improvement of the thermal diffusivity and the thermal conductivity of the material is difficult. In this embodiment of this application, a proportion of turbostratic stack structures of the carbon atom layers in the carbon material is high, and correspondingly, a proportion of the ABA stack structures is low. An increase in the proportion of the turbostratic stack structures of the carbon atom layers greatly improves the in-plane thermal diffusivity of the carbon material.

In an implementation of this application, a crystallographic L_{c} size (Length in C-axis, Length in C-axis) of a crystal grain in a single crystal of the carbon material 100 is greater than or equal to 50 nm. In some implementations of this application, the crystallographic L_{c} size of a crystal grain in a single crystal of the carbon material 100 is greater than or equal to 55 nm. In some implementations, the crystallographic L_{c} size of a crystal grain in a single crystal of the carbon material 100 is greater than or equal to 60 nm. In some implementations, the crystallographic L_{c} size of a crystal grain in a single crystal of the carbon material 100 is greater than or equal to 65 nm. In some implementations, the crystallographic L_{c} size of a crystal grain in a single crystal of the carbon material 100 is greater than or equal to 70 nm. In this application, the L_{c} size of a crystal grain of the carbon material is large, and therefore the carbon material has the pristine film feature while a thickness range is large. This facilitates application of the carbon material in a scenario in which requirements on heat dissipation, heat equalization, and a film thickness are high. Using a plurality of layers of adhesives for bonding to obtain a carbon material with a large thickness can be avoided. In this way, a heat dissipation requirement of a high-power device in future 5G can be met.

In an implementation of this application, a crystallographic Lₐ size of a crystal grain of the carbon material 100 is greater than or equal to 10 µm. In some embodiments, the crystallographic Lₐ size of a crystal grain of the carbon material 100 is 10 µm to 100 µm (including the two endpoints). Specifically, the crystallographic Lₐ size of a crystal grain of the carbon material 100 may be, for example, 10 µm, 20 µm, 30 µm, 40 µm, 50 µm, 60 µm, 70 µm, 80 µm, 90 µm, or 100 µm. In this application, the carbon material has a large single crystal Lₐ size. In this case, a large phonon free path is obtained. This improves the heat conduction performance of the carbon material, and high thermal diffusivity can be obtained. The Lₐ size of a crystal grain may be obtained through test according to GB/T 40069-2021 *Nanotechnologies-Measurement of the number of layers of graphene-related two-dimensional (2D) materials-Raman spectroscopy method.* Specifically, a Raman signal on the surface of the carbon material may be observed. A test wavelength is 1200 cm⁻¹ to 2800 cm⁻¹. A band from 1200 cm⁻¹ to 1800 cm⁻¹ is focused on. A signal-to-noise ratio is greater than 20. A plurality of sample points may be used on the carbon material for test. A laser wavelength used for test may be 638 nm laser. In this application, a ratio of a D peak (^{∼}1270 cm⁻¹) strength to a G peak (^{∼}1580 cm⁻¹) strength in the Raman spectra in test of the carbon material may be I_{D}/I_{G}<0.01, where I_{D}/I_{G} is a peak ratio of a D band to a G band of the Raman spectra.

In an implementation of this application, the carbon atom layers in the plurality of carbon atom layers are combined by van der Waals forces. A layer spacing between the plurality of stacked carbon atom layers may be greater than or equal to 0.3 nm and less than or equal to 0.5 nm. In some embodiments, the layer spacing between the plurality of stacked carbon atom layers may be greater than or equal to 0.335 nm and less than or equal to 0.5 nm. A smaller carbon layer spacing improves the in-plane heat diffusion performance of the carbon material.

The L_{c} size of the crystal grain and the spacing between the carbon atom layers can be measured according to an X-ray powder diffraction (X-ray Powder Diffraction, XRD) method. A signal on the surface of the carbon material is observed. A test angle is 10° to 60°. 20° to 30° is focused on, that is, information on a (001) plane. A plurality of sample points may be used on the carbon material for test. An excitation wavelength is 1.5406 Å. A copper (copper) K-α light source are used. The spacing between the carbon atom layers and the L_{c} size of a crystal grain are calculated based on information such as a peak strength, a peak position, and a full width at half maximum.

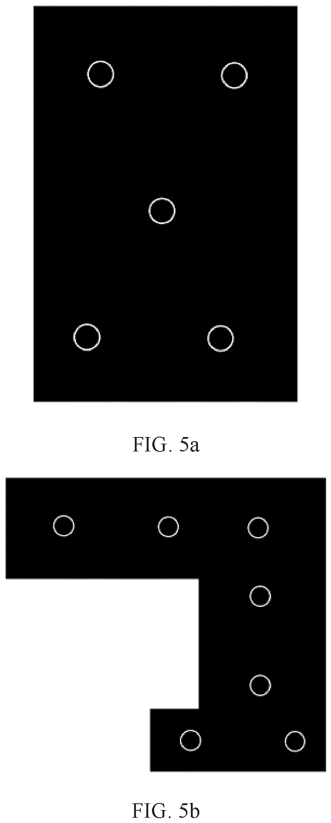

For example, characterization the foregoing parameters may be selection of sample points in FIG. 5a and FIG. 5b. As shown in FIG. 5a, for a carbon film, a carbon sheet, or a carbon plate in a regular shape, five sample points may be selected. As shown in FIG. 5b, for a carbon film, a carbon sheet, or a carbon plate in an irregular shape, seven sample points may be selected. Each sample point is in a geometric center of a relative area. Each sample point may be tested three times. Reference is made based on test results of at least 50% of the samples. Local defects and exceptions are not counted.

In an implementation of this application, a carbon-carbon double bond C=C proportion in the carbon material 100 is greater than or equal to 80%. The carbon-carbon double bond C=C proportion of the carbon material 100 is a proportion of carbon atoms that form a double bond in the carbon material 100, that is, a molar proportion. A higher carbon-carbon double bond C=C proportion of the carbon material 100 indicates higher graphitization of the carbon material, and higher graphitization facilitates obtaining of higher thermal diffusivity. In an implementation of this application, a carbon-carbon double bond C=C proportion of the carbon material 100 may be specifically, for example, 80%, 81%, 82%, 83%, 84%, 85%, 86%, 87%, 88%, 89% or 90%. The C=C proportion may be characterized by using X-ray photoelectron spectrometry (XPS). Specifically, a C fine spectrum (280 eV to 300 eV) is measured. After a C fine peak is obtained, Lorentzian Lorentzian peak fitting is performed. The C=C proportion is determined based on an X-ray intensity value of a peak splitting result.

In an implementation of this application, a breaking strength of the carbon material 100 is greater than or equal to 30 MPa. The breaking strength refers to the maximum tensile stress that a stretched sample can withstand before breaking. The breaking strength can characterize a tensile strength of the carbon material. The carbon material in this embodiment of this application has a high breaking strength, indicating that the carbon material has good flexibility performance and elasticity performance, excels at tensile resistance, and can be used in an application scenario in which there is a bending requirement. In some implementations of this application, the breaking strength of the carbon material 100 is greater than or equal to 40 MPa. In some embodiments of this application, the breaking strength of the carbon material 100 is 40 MPa to 80 MPa, specifically, for example, may be 40 MPa, 50 MPa, 51 MPa, 60 MPa, 65 MPa, 70 MPa, 75 MPa, or 80 MPa.

In this application, the elongation at break and the breaking strength of the carbon material may be obtained through test by using a tensile test machine with reference to GB 13022-91 (*Plastics-determination of tensile properties of films*). Specifically, the carbon material may be cut into a standard sample, a stress-strain curve is obtained by using the tensile test machine, and the elongation at break and the break strength are obtained by analyzing the stress-strain curve.

The carbon material 100 in embodiments of this application may be of a mixed crystal structure, that is, include both a single crystal and a polycrystal.

In an implementation of this application, the carbon material 100 may be a film, a sheet, a plate, or the like. In other words, the carbon material 100 may be a carbon film, a carbon sheet, or a carbon plate.

In an implementation of this application, the carbon material 100 may be obtained by graphitizing graphite oxide. A raw material of the graphite oxide is easy to obtain, which facilitates industrial production.

In an implementation of this application, in a process of producing the carbon material by using the graphite oxide, a volatile solvent is added to a graphite oxide solution, and the volatile solvent is evaporated to form the wrinkle structures; and/or a non-graphitized carbon material precursor is repeatedly squeezed and stretched in a first axial direction and/or a second axial direction to form the wrinkle structures, where the first axial direction and the second axial direction are perpendicular to each other, and the first axial direction and the second axial direction may be respectively the X direction and the Y direction shown in FIG. 2. In embodiments of this application, a method for rapid evaporation and drying of a volatile solvent is used to help form a plurality of randomly distributed micro wrinkle structures on a surface of a carbon material. The method for forming wrinkles is environment-friendly and fast, and toxic and harmful reduction agents, blowing agents, and the like are not used. Surface density of the formed wrinkle structures can be controlled and adjusted through control and adjustment of a type of the volatile solvent, a heating rate in evaporation, and the like. A production process is highly feasible. In this embodiment of this application, the non-graphitized carbon material precursor is repeatedly squeezed and stretched in the first axial direction and/or the second axial direction, to form a plurality of shrank macro wrinkle structures following an orientation distribution. The wrinkle formation method is easy to control, and the carbon material has high flexibility.

The carbon material provided in embodiments of this application has high thermal diffusivity and good bending performance, and has a pristine film feature while a thickness range is large. The carbon material may be used in various scenarios in which there is a heat dissipation requirement. The carbon material can adapt to development requirements of high-power devices in 5G and 6G, and meet a heat dissipation requirement of a foldable device. For example, the carbon material in embodiments of this application may be used for heat equalization and heat dissipation of a heating power component or assemble on a circuit board, or may be used for heat equalization, heat dissipation, and the like of a semiconductor chip or a heating chip that is inside a packaging assembly, and in particular, may be used in a foldable electronic device. In a bending process of the foldable electronic device, materials at all layers of the device is stretched or compressed, and cross-section lengths of the materials at all layers change in different cross sections. The flexible and bendable carbon material in embodiments of this application can directly absorb the change, so that heat dissipation and heat equalization of the foldable electronic device are implemented in a simple and low-cost manner. In addition, mass production and a production process of the carbon material in embodiments of this application are highly feasible, and expanded production can be implemented. In addition, the carbon material in this application is light. By using the carbon material in this application for heat dissipation rather than a conventional aluminum plate or copper plate, a weight of a device can be effectively reduced, which provides great weight reduction benefits. In this application, the carbon material may be independently used in a form of a film or plate, or may be processed into a sheet material, a film material, or a specific three-dimensional shape for use; or adhesion of the carbon material is increased by using an adhesive, by brushing glue, or the like, and then a use manner of the carbon material is pasting; or the carbon material may be soldered with a metal mechanical part to form a heat dissipation structure assembly or the like.

An embodiment of this application further provides a method for producing the foregoing carbon material. The method including the following steps.

S101: Disperse large-diameter graphite oxide in a solvent, and add a catalyst and a volatile solvent to obtain a graphite oxide slurry.

S102: Coat a substrate with the graphite oxide slurry and perform drying, perform preliminary thermal reduction to obtain a carbon material precursor, perform wrinkle processing on the carbon material precursor by using a biaxial drawing device, and then perform graphitization through high-temperature reduction, to obtain a carbon material.

In the foregoing step S101, the solvent may be water. The catalyst may be one or more of a transition metal catalyst and a boron-based catalyst. The transition metal catalyst may be specifically a transition metal or a transition metal compound. The transition metal catalyst may be a catalyst based on iron, cobalt, or nickel. The catalyst based on the iron, cobalt, or nickel may specifically include one or more of iron oxide nanoparticles, ferrocene, iron(tetraphenylporphyrin), ferrous oxalate, iron acetylacetonate, ferric chloride, nickel chloride, nickel oxide, cobalt chloride, and cobalt oxide. The boron-based catalyst may be one or more of triphenyl borane, trimethyl borate, and bis(neopentyl glycolato)diboron. A content of the transition metal catalyst is determined based on a content of transition metal atoms. The content of the transition metal atoms accounts for 0.005% to 0.1% of the content of the graphite oxide. Preferably, the content of the transition metal atoms accounts for 0.05% to 0.08% of the content of the graphite oxide. The content of boron-based catalyst is determined based on a content of boron atoms. The content of the boron atoms accounts for 0.05% to 1% of the content of the graphite oxide. Preferably, the content of boron atoms accounts for 0.1% to 0.5% of the content of the graphite oxide. The added catalyst can improve a graphitization repair degree of the carbon material, and can enable the carbon material to form more turbostratic stack modes, thereby significantly increasing a crystal size of the graphite oxide in subsequent high-temperature processing. In this way, a highly oriented carbon material with high thermal diffusivity and thermal conductivity can be obtained. Therefore, by using the catalytic graphitization solution in this application, a turbostratic stack proportion of the carbon atom layers in the carbon material can be increased, and the thermal diffusivity of the carbon material can be increased.

In the foregoing step S101, the volatile solvent is a highly volatile solvent, and may be specifically, for example, ethanol, acetone, ethyl acetate, diacetone alcohol, methanol, dichloromethane, trichloroethylene, and carbon sulfide. In consideration of environmental protection, ethanol may be preferred. An amount of the added volatile solvent may be 1% to 70%, and in some embodiments, the amount of the added volatile solvent may be 15% to 60%. In some embodiments, the amount of the added volatile solvent may be, for example, 1%, 5%, 10%, 15%, 20%, 25%, 30%, 45%, 50%, 60%, or 70%. The amount of the added volatile solvent is a mass fraction of the volatile solvent in the entire graphite oxide slurry. The volatile solvent has a low boiling point, and may vaporize rapidly. In a process of coating, drying, and preliminary thermal reduction in subsequent step S102, the volatile solvent can be used to achieve a rapid evaporation effect. Under action of high surface tension of the solvent, the graphite oxide film shrinks quickly, and then a plurality of micro wrinkle structures are generated. Increase in the amount of the volatile solvent helps formation of the wrinkle structures. An appropriate content of the volatile solvent can ensure good dispersion of the graphite oxide and generation of a large quantity of wrinkle structures of the carbon material.

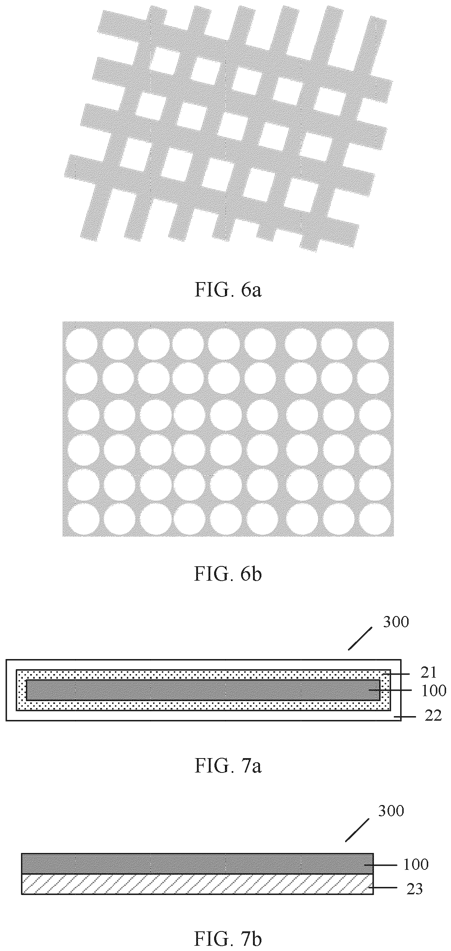

In this implementation of this application, to form better wrinkle structures in a larger quantity, an evaporation speed of moisture and the volatile solvent in the graphite oxide slurry may be improved through convection enhancement, temperature rise, volatilization enhancement, or the like, so that more micro wrinkle structures of a graphite oxide film can be generated. A manner of convection enhancement may be using a porous substrate as the substrate in step 102, where the porous substrate may be, for example, a woven polymer substrate shown in FIG. 6a or a polymer substrate with evenly distributed holes shown in FIG. 6b. The foregoing manner of temperature rise and volatilization enhancement may be increasing a heating rate and a baking temperature during drying. In some embodiments, the heating rate during drying may be greater than or equal to 10°C/min, and the baking temperature may be 120°C to 400°C. In some embodiments, the heating rate may be specifically 10°C/min, 11°C/min, 12°C/min, 13°C/min, 14°C/min, 15°C/min, 16°C/min, 17°C/min, 18°C/min, 19°C/min, or 20°C/min. In some embodiments, the baking temperature may be 120°C, 150°C, 200°C, 250°C, or the like. In this implementation of this application, increase in the heating rate during drying can accelerate the volatilization of the volatile solvent, so that the graphite oxide film can shrink more rapidly. This facilitates formation of the micro wrinkle structures, thereby improving surface density of wrinkle structures of an obtained carbon material, and correspondingly improving elongation at break of the carbon material. In this embodiment of this application, a method for rapid evaporation and drying of a volatile solvent is used to help form a plurality of randomly distributed micro wrinkle structures on the surface of the carbon material. The method for forming the wrinkles is environment-friendly and fast, and toxic and harmful reduction agents, blowing agents, or the like are not used. The surface density of the formed wrinkle structures can be controlled and adjusted through control and adjustment of a type of the volatile solvent, a heating rate in evaporation, and the like. A production process is easy to control, and therefore expanded production is easy.

In an implementation of this application, preliminary thermal reduction performed on the dried graphite oxide film may be performed in an inert atmosphere, where the inert atmosphere may be, for example, a nitrogen atmosphere. In a process of preliminary thermal reduction, a thermal reduction temperature may be 300°C to 800°C, a heating rate may be 1°C to 5°C/min, and a soaking time may be 1 hour to 5 hours. In some embodiments, the thermal reduction temperature may be, for example, 300°C, 350°C, 400°C, 450°C, 500°C, 600°C, 700°C, 800°C, or the like. In some embodiments, the heating rate of the thermal reduction temperature may be, for example, 1°C/min, 2°C/min, 3°C/min, 4°C/min, or 5°C/min. In some embodiments, the soaking time may be 1 hour, 2 hours, 3 hours, 4 hours, 5 hours, or the like.

In some implementations of this application, a carbon source repair agent may be further added to the graphite oxide slurry. The carbon source repair agent may include an organic molecule having high water solubility, for example, pyrenebutyric acid and ascorbic acid. The added carbon source repair agent can improve the turbostratic stack proportion of the carbon atom layers, and facilitates obtaining of the carbon material with high thermal diffusivity.

In an implementation of this application, a large-diameter graphite oxide may be produced through the following low-temperature processing.

Concentrated sulfuric acid, potassium permanganate, or both the concentrated sulfuric acid and potassium permanganate are added to a raw graphite material, so that oxidation lift-off can be performed on the graphite for a period of time at a temperature between 20°C and 40°C, to obtain a large-diameter graphite oxide solution.

In this embodiment of this application, the concentrated sulfuric acid and potassium permanganate are used as oxidants, and large-diameter single-layer graphite oxide may be obtained through oxidation lift-off at a low temperature. The oxidants used in the foregoing method of producing the large-diameter graphite oxide at a temperature are the concentrated sulphuric acid and potassium permanganate, where a mass fraction of sulphuric acid in the concentrated sulphuric acid may be 85% to 98.3%. In some embodiments, the mass fraction of the sulphuric acid may be greater than 95%. High concentration of the concentrated sulfuric acid facilitates obtaining of the single-layer graphite oxide. Concentration of the potassium permanganate may be 0.01 g/ml to 0.2 g/ml. In some embodiments, the concentration of the potassium permanganate may be 0.05 g/ml to 0.15 g/ml.

In some embodiments, in the entire process of oxidation lift-off of the raw graphite material, a temperature may be controlled to maintain at 25°C to 35°C. Specifically, in some embodiments, in the entire process of oxidation lift-off of the graphite oxide, the temperature may be controlled to maintain at about 30°C. In some embodiments, the temperature in oxidation lift-off may be, for example, 25°C, 26°C, 27°C, 28°C, 29°C, 30°C, 32°C, 34°C, 35°C, or the like. A reaction time of the foregoing oxidation lift-off may be two to five hours. In some embodiments, the reaction time may be controlled to be three to four hours, so as to obtain the large-size single-layer graphite through oxidation lift-off.

The raw graphite material may be, but is not limited to, one or more of expandable graphite, flake graphite, high purity graphite, and kish graphite. Preferably, the raw graphite material is the expandable graphite. A diameter of the raw graphite material may be 100 µm to 300 µm. In some embodiments, the diameter of the raw graphite material may be 150 µm to 200 µm.

In the foregoing produced large-diameter graphite oxide solution, a surface oxygen content of the large-diameter graphite oxide is identified by using X-ray photoelectron spectrometry, a proportion of the oxygen content is less than or equal to 40% and is greater than or equal to 15%, and an average particle size is greater than or equal to 100 µm. In some embodiments, the average particle size of the large-diameter graphite oxide is greater than or equal to 100 µm and is less than or equal to 150 µm. A rate of single-layer graphite oxide contained in the large-diameter graphite oxide solution is greater than 95%, and a manner of obtaining a high rate of single-layer graphite oxide sheets are not limited to manners such as centrifugal screening and filter screening.

In this embodiment of this application, the oxygen content of the graphite oxide can be reduced from a conventional content of more than 50% to less than 40% by implementing the foregoing low-temperature oxidation process, and the diameter of the single-layer graphite oxide is large. In a conventional solution, only a graphite oxide sheet material of 20 to 30 µm can be produced. However, in this embodiment of this application, single-layer graphite oxide with a diameter greater than 100 µm can be produced by implementing a low-temperature oxidation process in which the concentrated sulfuric acid and the potassium permanganate are used as the oxidants.

In the foregoing step S102, wrinkle processing is performed on the carbon material precursor by using the biaxial drawing device. Specifically, the carbon material precursor is repeatedly squeezed and stretched (that is, the carbon material is first squeezed, pressure release is performed, and then the carbon material is squeezed) in a first axial direction and/or a second axial direction that are perpendicular to each other, to form the plurality of shrank macro wrinkle structures following an orientation distribution. In this way, the elongation at break of the carbon material is further improved. A biaxial drawing (biaxial drawing) device is a device that performs stretching and squeezing in longitudinal and horizontal directions of a film or plate plane in production of a film or a plate. Stretching and squeezing operations in the two axial directions may be performed simultaneously, or may be performed successively. In this application, according to a requirement, wrinkle processing may be performed only in the first axial direction, or the wrinkle processing may be performed only in the second axial direction, or the wrinkle processing may be performed in both the first axial direction and the second axial direction. The method of using the biaxial drawing device to perform wrinkle processing for wrinkle formation is easy to control, and the carbon material has high flexibility. Specifically, wrinkle processing may be as follows. The carbon material precursor is clamped in a special biaxial drawing device, and reciprocating squeezing actions are applied. Each squeezing amplitude is a strain of 10% to 80%, that is, a proportion of a length of squeezing compression to an original length is 10% to 80%, specifically, for example, 10%, 20%, 30%, 40%, 50%, 60%, 70% and 80%.

In the foregoing step S102, a temperature at which graphitization through high-temperature reduction is performed may be 2200°C to 3500°C, specifically, for example, may be 2200°C, 2500°C, 2900°C, 3000°C, 3100°C, 3200°C, 3300°C, and 3500°C. A heating rate in the process of graphitization through high-temperature reduction may be 5°C/min to 20°C/min. A soaking time of the process of graphitization through high-temperature reduction may be 2 hours to 6 hours. After graphitization through high-temperature reduction, the carbon material is cooled to a room temperature through free cooling, and then high-temperature and high-pressure processing is performed. After calendering, a final carbon film is obtained.

In this implementation of this application, the wrinkle structures may be formed through rapid volatilization of a volatile solvent according to a requirement, or the wrinkle structures may be formed through wrinkle processing performed by a biaxial drawing device, or the wrinkle structures may be formed through both rapid volatilization of a volatile solvent and wrinkle processing performed by the biaxial drawing device.

Refer to FIG. 7a and FIG. 7b. An embodiment of this application provides a heat dissipation assembly 300. The heat dissipation assembly 300 includes the foregoing carbon material 100 in embodiments of this application. The heat dissipation assembly 300 may include only the carbon material 100, or may include the carbon material 100 and another heat dissipation material or element (for example, a vapor chamber or a heat dissipation film). In other words, the carbon material 100 is used together with another heat dissipation material or element. In some embodiments, the heat dissipation assembly 300 further includes a heat dissipation element that is attached to the surface of the carbon material 100 or embedded in the carbon material 100. The heat dissipation element may be a heat pipe, a vapor chamber, a heat dissipation film, a thermally conductive adhesive, or the like. As shown in FIG. 7a, in some embodiments of this application, the heat dissipation assembly 300 includes the carbon material 100, an adhesive layer 21 disposed on the surface of the carbon material 100, and a protective layer 22 disposed on a surface of the adhesive layer 21. The protective layer 22 may be a PI (polyimide) film, a PET (polyethylene terephthalate) film, or the like, or may be a single-sided adhesive or a double-sided adhesive. As shown in FIG. 7b, in some embodiments of this application, the heat dissipation assembly 300 includes the carbon material 100 and a vapor chamber 23 disposed on the surface of the carbon material 100. The carbon material 100 has a protective layer, and is partially or completely glued to the vapor chamber 23. This is not shown in detail in FIG. 7b. The heat dissipation assembly 300 in this embodiment of this application may be configured to dissipate heat of a heating element, and transfer the heat generated by the heating element to a heat dissipation end in a timely manner, to implement heat conduction and heat equalization. The heat dissipation assembly 300 may be used in various electronic devices that have a heat dissipation requirement, for example, may be used in an electronic device like a battery, a mobile phone, a tablet computer, a notebook computer, a watch, or a band, and in particular, may be used in a foldable electronic device, to meet both a bending resistance requirement and a heat dissipation requirement. Specifically, the heat dissipation assembly 300 may be disposed between circuit boards, between a circuit board and an electronic device housing, between a power component and an electronic device housing, or pasted on a chip.

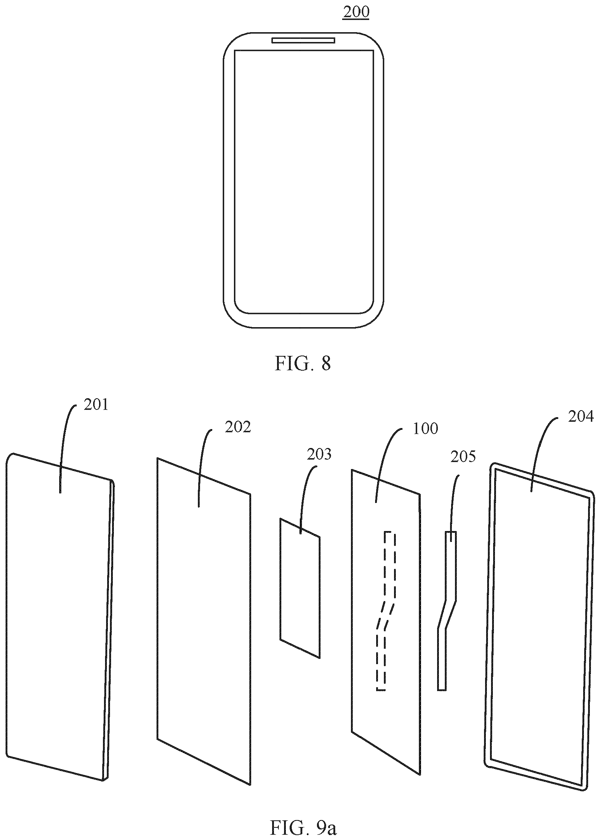

Refer to FIG. 8. An embodiment of this application further provides an electronic device 200. The electronic device 200 includes the foregoing carbon material 100 in embodiments of this application, and the carbon material 100 may be used as a heat dissipation member to dissipate heat for the electronic device 200. In some embodiments, the electronic device 200 may include the heat dissipation assembly 300. The carbon material 100 provided in embodiments of this application is used in the electronic device 200 for heat dissipation and heat equalization. The carbon material has good heat dissipation performance and heat equalization performance. In addition, the carbon material is flexibly disposed in the electronic device. A shape and a size of the carbon material are designed flexibly. The carbon material is easy to assemble and fix. In this way, a heat dissipation requirement of the electronic device can be met. In addition, the carbon material 100 provided in embodiments of this application further has good flexibility performance and bending performance, and can be directly attached to an entire surface. The carbon material 100 can meet a cross-hinge heat dissipation requirement of a foldable electronic device, effectively equalize heat for screens, and reduce a temperature difference between the screens. The electronic device 200 may be various electronic devices that have a heat dissipation requirement, for example, may be various devices that have a heat dissipation requirement, such as a mobile phone, a tablet computer, a notebook computer, a wearable device (like glasses, a watch, or a band), a display device, an AR device, a VR device, an AR/VR device, a television, an adapter, a router, a vehicle-mounted device, a vehicle-mounted display, a gateway, a set-top box, a charging base, a heat dissipation assembly, a battery system, a power component, and a packaging assembly. Particularly, the electronic device in this embodiment of this application may be a foldable electronic device.

An example in which the electronic device 200 is a mobile phone is used below to specifically describe application of the carbon material 100 in the electronic device 200 in this embodiment of this application.

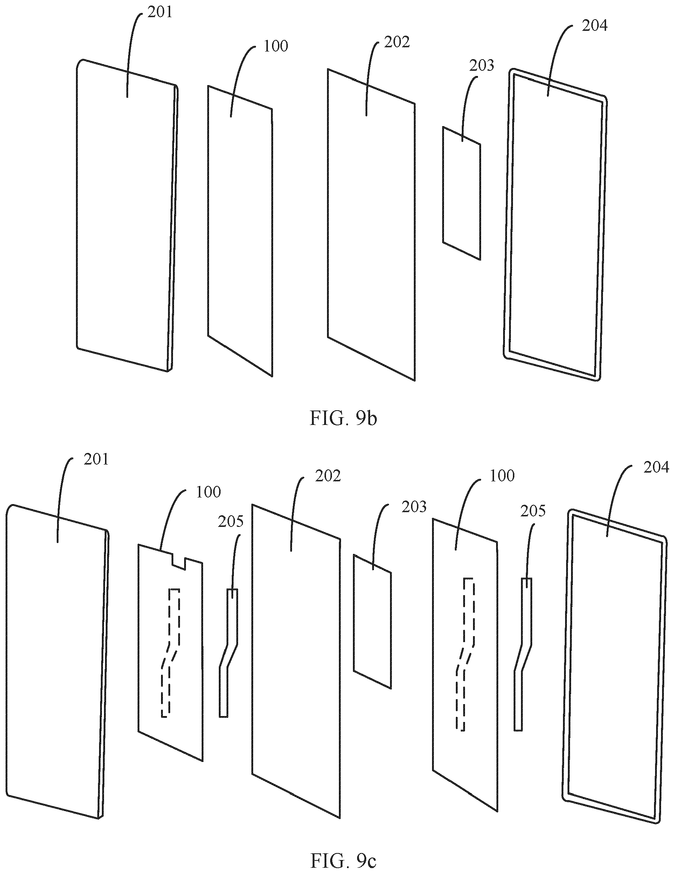

Refer to FIG. 9a, FIG. 9b, and FIG. 9c. FIG. 9a, FIG. 9b, and FIG. 9c are diagrams of exploded structures of an electronic device 200. The electronic device 200 includes a display 201, a middle frame 202, a circuit board 203, and a rear cover 204. The middle frame 202 is located between the display 201 and the rear cover 204. The middle frame 202 is configured to carry the display 201 and the circuit board 203. The carbon material 100 may be located between the middle frame 202 and the rear cover 204 as shown in FIG. 9a, or the carbon material 100 may be located between the middle frame 202 and the display 201 as shown in FIG. 9b, or carbon materials 100 may be disposed between the middle frame 202 and the rear cover 204 and between the middle frame 202 and the display 201 as shown in FIG. 9c. A heating component, for example, a chip, is disposed on the circuit board 203. The heating component may be disposed on one side or two sides of the circuit board 203. The carbon material 100 inside the electronic device 200 may be disposed to dissipate heat for the circuit board 203 and the display 201, so that heat generated by a heating point inside the electronic device 200 can be quickly conducted, thereby avoiding generation of the heating point inside the electronic device 200, and improving user experience and security stability of the electronic device 200. Same carbon films, carbon sheets, or carbon plates may be equal in thickness or unequal in thickness. A shape and a size of the carbon material are not limited. The carbon material may be in a regular shape like a square, or may be in an irregular shape. A shape, a thickness, and an X-Y plane size of the carbon material disposed between the middle frame 202 and the rear cover 204 may be the same as or different from those of the carbon material between the middle frame 202 and the display 201.

The carbon material 100 may be fixedly disposed on the middle frame 202 or the rear cover 204, and specifically, may be connected to the middle frame 202 or the rear cover 204 through bonding with an adhesive or soldering, or injection molding of the carbon material 100 may be performed inside the rear cover 204, where injection molding helps reduce an overall thickness of the electronic device. Alternatively, the carbon material 100 may be partially attached to the circuit board 203 or an auxiliary mechanical part of the circuit board 203, for example, a shielding cover or a metal injection part; and the other part is laid between the battery and a wireless charging or NFC coil.

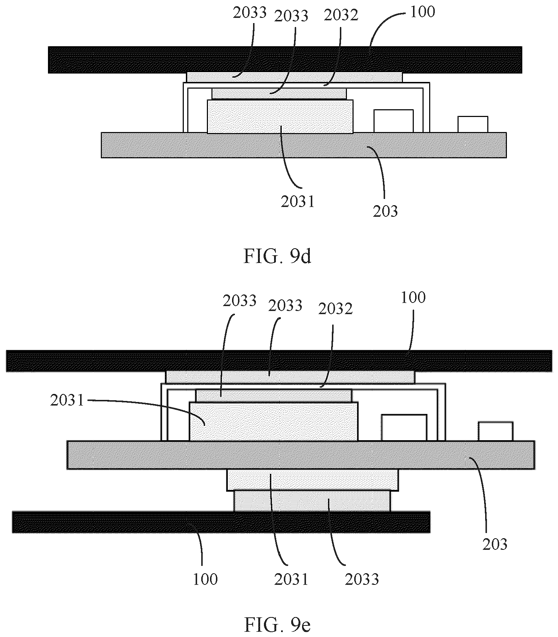

In some embodiments, as shown in FIG. 9d and FIG. 9e, a shielding can 2032 and/or a thermal interface material 2033 may be further disposed between the carbon material 100 and a heating component 2031 on the circuit board 203. Disposal of the shielding can and the thermal interface material can promote heat diffusion and conduction. As shown in FIG. 9d, a heating component is disposed on one side of the circuit board 203, and both the shielding can 2032 and the thermal interface material 2033 are disposed between the carbon material 100 and the heating component 2031 on the circuit board 203. As shown in FIG. 9e, heating components are disposed on both sides of the circuit board 203, and carbon materials 100 are disposed on the heating components 2031 on both sides. Athermal interface material 2033 is disposed between the carbon material 100 and the heating component 2031 on one side. A shielding can 2032 and a thermal interface material 2033 are disposed between the carbon material 100 and the heating component 2031 on the other side.

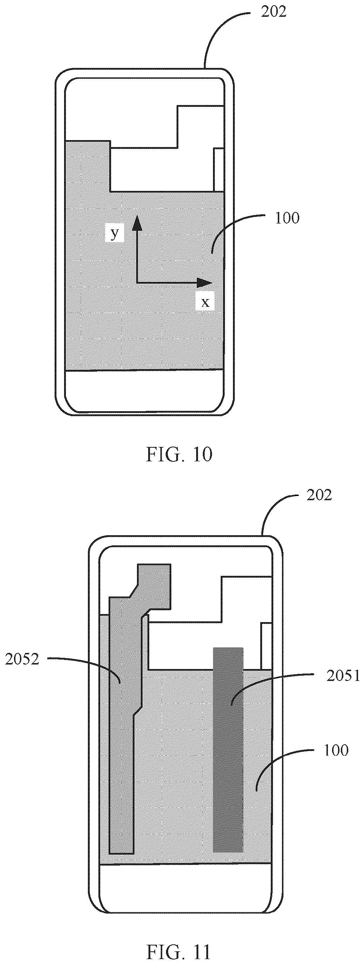

Refer to FIG. 10. FIG. 10 is a diagram of a structure in which the carbon material 100 is fastened to the middle frame 202. In an implementation of this application, a specific size and shape of the carbon material 100, and disposal positions of the carbon material 100 on the middle frame 202 and the rear cover 204 may be designed based on a specific model of the electronic device, an actual heat dissipation requirement, and the like. This is not specifically limited in this application. In some embodiments, the carbon material 100 may cover a main heating component on the circuit board 203, or may cover each heating component on the circuit board 203, or may cover the entire circuit board 203. In some embodiments, an orthographic projection of the carbon material 100 on the middle frame 202 overlaps or coincides with an orthographic projection of the circuit board 203 on the middle frame 202. In some embodiments, the carbon material 100 may also be disposed around the circuit board 203, that is, the orthographic projection of the carbon material 100 on the middle frame 202 does not overlap with the orthographic projection of the circuit board 203 on the middle frame 202. In this embodiment of this application, the carbon material has high thermal diffusivity in the X-Y plane direction, so that a heat flow can be quickly conducted in the X-Y plane direction, thereby implementing quick heat dissipation inside the electronic device and avoiding generation of a heating point.

Refer to FIG. 9c and FIG. 11. In some implementations of this application, to further improve the heat dissipation performance of the electronic device 200, the electronic device 200 further includes a two-phase liquid cooling heat dissipation member 205. The two-phase liquid cooling heat dissipation member 205 may include a heat pipe 2051 and/or a vapor chamber 2052, a loop heat pipe, or the like. In other words, in the electronic device 200, the heat pipe 2051 may be further disposed, the vapor chamber 2052 may be disposed, or both the heat pipe 2051 and the vapor chamber 2052 may be disposed. This may be specifically set according to an actual requirement. The two-phase liquid cooling heat dissipation member is fastened to the surface of the carbon material, or the two-phase liquid cooling heat dissipation member is partially or completely embedded in the carbon material. The carbon material may be of a 2D structure or 2.5D structure.

In some implementations of this application, as shown in FIG. 11, the heat pipe 2051 and the vapor chamber 2052 are fastened to the surface of the carbon material 100. To be specific, the heat pipe 2051 and the vapor chamber 2052 are attached to and contact with the carbon material 100. Specifically, the heat pipe 2051 and the vapor chamber 2052 may be fixedly connected to the carbon material 100 through bonding with an adhesive or soldering.

In some implementations of this application, as shown in FIG. 9c, the two-phase liquid cooling heat dissipation member 205 is partially or completely embedded in the carbon material 100. Specifically, the carbon material 100 may be provided with a groove, and the two-phase liquid cooling heat dissipation member 205 is partially or completely embedded in the groove.

In an implementation of this application, the carbon material 100 is used in combination with the heat pipe 2051 and/or the vapor chamber 2052 to obtain good heat diffusion performance, and a heat diffusion effect of the carbon material 100 is far better than that of a conventional heat pipe or vapor chamber.

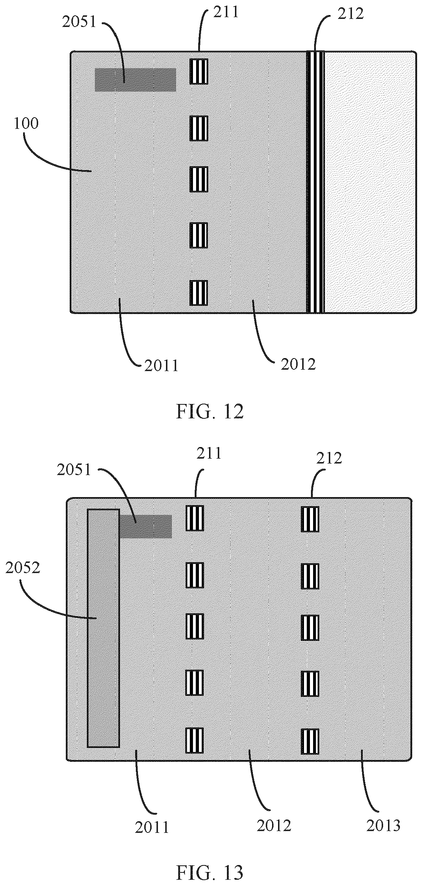

Refer to FIG. 12 and FIG. 13. In some embodiments of this application, the electronic device 200 may alternatively be a foldable device. FIG. 12 is a diagram of a triple-screen foldable device in which a carbon material is disposed in two screens. FIG. 13 is a diagram of a triple-screen foldable device in which a carbon material is disposed in three screens. Refer to FIG. 12. The electronic device 200 includes a first display area 2011, a second display area 2012, a third display area 2013, a first folding part 211, and a second folding part 212. The carbon material 100 is disposed across a hinge, that is, across the first folding part 211, and simultaneously covers the first display area 2011, the second display area 2012, and the first folding part 211. Refer to FIG. 13. The electronic device 200 includes a first display area 2011, a second display area 2012, a third display area 2013, a first folding part 211, and a second folding part 212. The carbon material 100 is disposed across hinges, that is, across the first folding part 211 and the second folding part 212, and simultaneously covers the first display area 2011, the first folding part 211, the second display area 2012, the second folding part 212, and the third display area 2013. The carbon material 100 in embodiments of this application has good bending performance and heat diffusion performance, and may be disposed across hinges to meet a bending requirement and a heat dissipation requirement of a multi-screen foldable device like a dual-screen foldable device or a triple-screen foldable device. To improve the heat dissipation performance of the foldable device, as shown in FIG. 12 and FIG. 13, the heat pipe 2051 and/or the vapor chamber 2052 may be further disposed on the carbon material 100 in the foldable device.

In an implementation of this application, the carbon material 100 may be in a regular shape, or the shape may be designed as an irregular shape based on an internal structure of the device, a display requirement, or the like. A size of the carbon material 100 may also be designed according to an actual requirement.

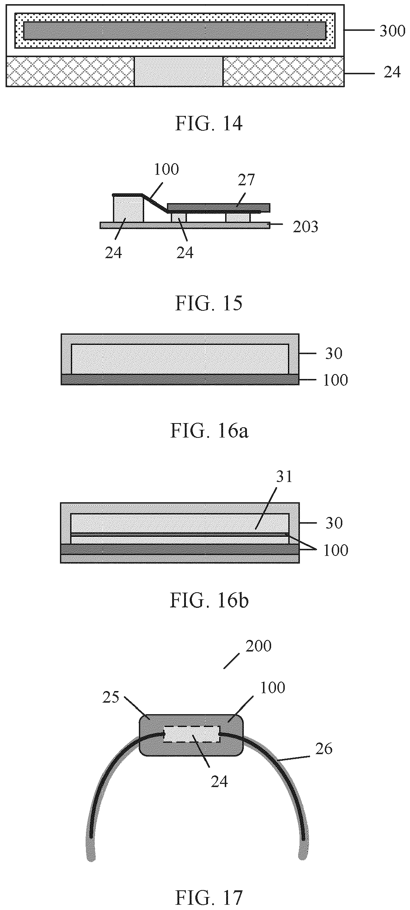

Refer to FIG. 14. In some embodiments of this application, the electronic device 200 includes a heating element 24 and a heat dissipation assembly 300 disposed on the heating element 24. The heating element 24 may be a display assembly, a heating chip, or the like. Alternatively, the heating element 24 may be a foldable heating element, for example, a foldable display assembly or a foldable heating chip.

In some embodiments of this application, the carbon material 100 has excellent bending performance, and may be attached to surfaces of a plurality of heating elements 24 at different heights. Refer to FIG. 15. FIG. 15 is a diagram of attaching the carbon material 100 to surfaces of a plurality of heating chips at different heights. It can be learned from FIG. 15 that the carbon material 100 is attached to surfaces of a plurality of heating chips 24 at different heights, and a bending structure of the carbon material 100 forms. In engineering, the shielding can 2032 and the thermal interface material 2033 shown in FIG. 9d and FIG. 9e may be laid between the heating chip 24 and the carbon material 100. To improve a heat dissipation effect, the shielding can 2032 may be provided with a through hole, and there may be only one thermal interface material 2033 between the heating chip 24 and the carbon material 100.

In embodiments of this application, a disposal position of the carbon material 100 in the electronic device 200 is not limited. For example, when the carbon material 100 is configured to dissipate heat for the display assembly in the electronic device 200, in some embodiments, the carbon material 100 may be disposed outside the display assembly 30 as shown in FIG. 16a, and may be specifically disposed on a housing of the display assembly 30, for example, through injection molding; and in some embodiments, the carbon material 100 may be disposed inside the display assembly 30 as shown in FIG. 16b, and may be specifically disposed above, below, or inside a flexible display layer 31 of the display assembly 30.

Refer to FIG. 17. In some embodiments, the electronic device 200 is a watch. The watch includes a watch face 25 and a watch band 26 connected to two ends of the watch face 25. A heating chip 24 is disposed in the watch face 25, the carbon material 100 is disposed around the heating chip 24, and the carbon material 100 is configured to transfer heat generated by the heating chip 24 from the watch face 25 to the watch band 26 in a timely manner, so as to dissipate heat of the watch.

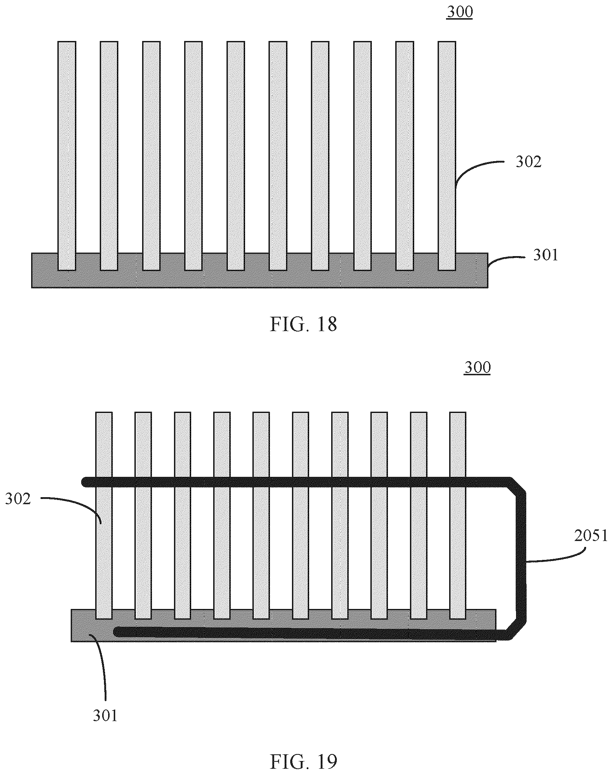

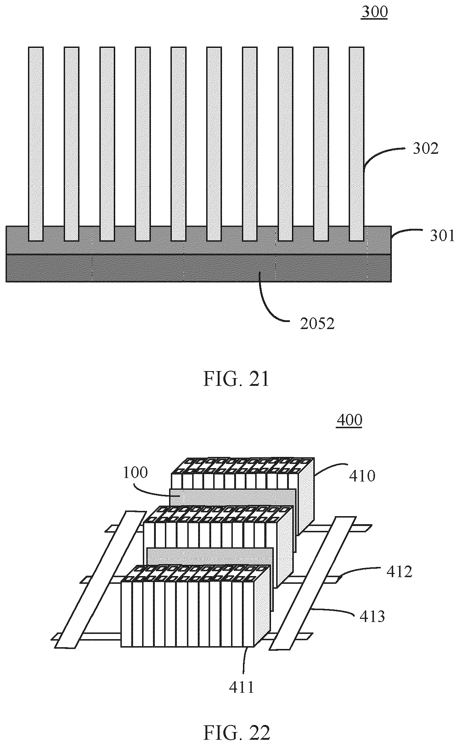

Refer to FIG. 18 and FIG. 21. An embodiment of this application further provides a heat dissipation assembly 300. The heat dissipation assembly 300 includes the foregoing carbon material 100 in embodiments of this application. In an implementation of this application, the heat dissipation assembly 300 includes a base 301 and a heat dissipation fin 302 disposed on the base 301. In some implementations, the foregoing carbon material 100 is used in the heat dissipation fin 302. In some embodiments, the foregoing carbon material 100 is used in the base 301. In some embodiments, the carbon material 100 is used in both the base 301 and the heat dissipation fin 302. The heat dissipation fin 302 may be fastened to the base 301 through soldering, bonding by using an adhesive, by using an interference fit, or the like.

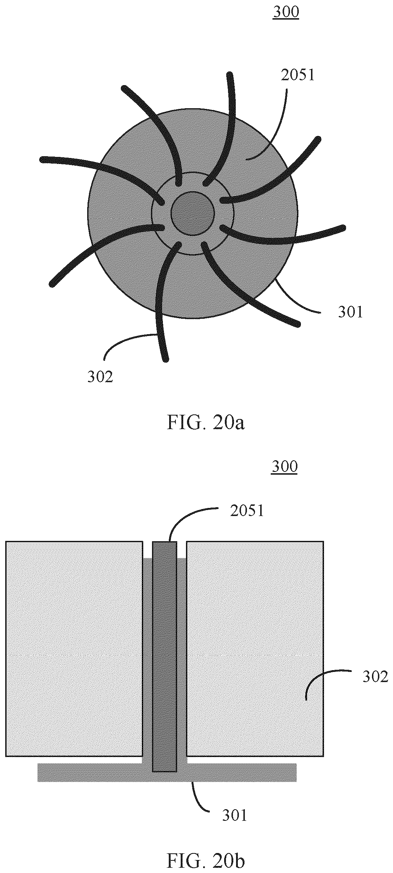

In an implementation of this application, the heat dissipation assembly 300 further includes a heat pipe 2051 and/or a vapor chamber 2052 connected to the base 301 and the heat dissipation fin 302. In some implementations of this application, the heat dissipation assembly 300 is a heat-pipe heat dissipation assembly. In some implementations, the heat dissipation assembly 300 is a vapor-chamber heat dissipation assembly. Refer to FIG. 19. FIG. 19 is a diagram of a structure of a heat-pipe heat dissipation assembly according to an embodiment of this application. A heat pipe 2051 is connected to a base 301 and a heat dissipation fin 302. Refer to FIG. 20a and FIG. 20b. FIG. 20a and FIG. 20b are diagrams of a structure of a heat-pipe heat dissipation assembly according to another embodiment of this application. FIG. 20a is a diagram of a top view of the structure. FIG. 20b is a diagram of a section view of the structure. In the heat-pipe heat dissipation assembly shown in FIG. 20a and FIG. 20b, the heat dissipation fin 302 is an arc-shaped heat dissipation fin, and the carbon material 100 in this embodiment of this application is used in the arc-shaped heat dissipation fin. Because the carbon material 100 in this application has good bending performance, a requirement of an arc-shaped setting can be met. The heat dissipation fin 302 has higher heat conduction performance and lower density compared with those of a copper heat dissipation device and an aluminum heat dissipation device. The heat pipe 2051 disposed in the middle of the arc-shaped heat dissipation fin 302 may strengthen heat transfer between the base 301 and the heat dissipation fin 302. Refer to FIG. 21. FIG. 21 is a diagram of a structure of a vapor-chamber heat dissipation assembly according to an embodiment of this application. A vapor chamber 2052 is connected to a base 301. The vapor-chamber heat dissipation assembly may be used in a large heating device like a server, to efficiently implement heat equalization and heat dissipation, so as to maintain normal operation of the device.

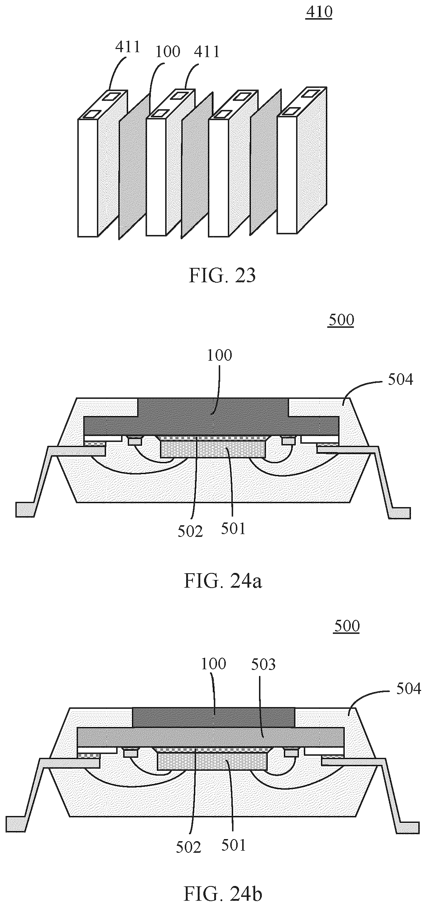

Refer to FIG. 22. An embodiment of this application further provides a battery system 400. The battery system 400 includes a plurality of battery packs 410. Each battery pack 410 includes a plurality of single cells 411 connected in series. A heat dissipation apparatus is disposed below the battery pack 410. In some embodiments, the heat dissipation apparatus may include a vapor chamber 412 and a coolant pipe 413. Refer to FIG. 22. In some embodiments of this application, for heat dissipation, the carbon material 100 is disposed between the plurality of battery packs 410, that is, between a battery pack 410 and another battery pack 410. Refer to FIG. 23. In some embodiments of this application, for heat dissipation, the carbon material 100 is disposed between the plurality of single cells 411 connected in series, that is, between one single cell 411 and another single cell 411. In some embodiments, the carbon material 100 may also be disposed between the battery packs 410 and between the single cells 411 for heat dissipation. In an actual application, the carbon material 100 may be used in combination with an insulation film, an insulation adhesive, a heat insulation material, a thermal storage material, a fire extinguishing material, and the like. These materials may be laid on the carbon material. It should be noted that the carbon material in this application has a melting point greater than or equal to 3000°C, and excels at heat resistance and heat equalization. In this application, the carbon material is bendable, and may further absorb battery expansion or impact deformation. This improves battery safety and stability.

In this embodiment of this application, the thermal diffusivity of the carbon material in the X-Y plane direction is far higher than the thermal diffusivity in the Z direction, and the carbon material is anisotropic material. When thermal runaway occurs on a single cell in the battery system 400, after heat is transferred to the carbon material, the heat can be quickly transferred to the heat dissipation apparatus with high heat diffusion performance of the carbon material in the X-Y plane direction, and the Z-plane direction with low heat diffusion performance can prevent heat transfer to a near normal cell. In this way, a chain reaction caused by thermal runaway can be avoided. Therefore, the carbon material in this embodiment of this application is disposed between the battery packs or between the single cells, and an anisotropy of the carbon material can be used to effectively control a heat flow direction, avoid thermal runaway spreading between the single cells, and efficiently transfer heat to heat dissipation apparatuses above and below the single cells.

In this embodiment of this application, to more effectively suppress spread of the thermal runaway of the battery, a heat buffer layer may be disposed on one side or two sides of the surface of the carbon material 100. The heat buffer layer may perform a heat insulation function. Once thermal runaway occurs on a single cell in the battery system 400, thermal runaway can be prevented from spreading from a single cell on which thermal runaway occurs to another single cell. The heat buffer layer may include one or more of magnesium carbonate, a heat-resistant resin material, and a thermal insulation gel material. In some embodiments, the heat buffer layer is a composite layer of the magnesium carbonate and the heat-resistant resin material. In some embodiments, the heat buffer layer is a composite layer of the magnesium carbonate, the heat-resistant resin material, and the thermal insulation gel material.

The battery system 400 in this embodiment of this application may be used in fields such as electric vehicles of various types (for example, an electric vehicle and an electric bicycle), an industrial power system (like a photovoltaic energy storage system), and the like.

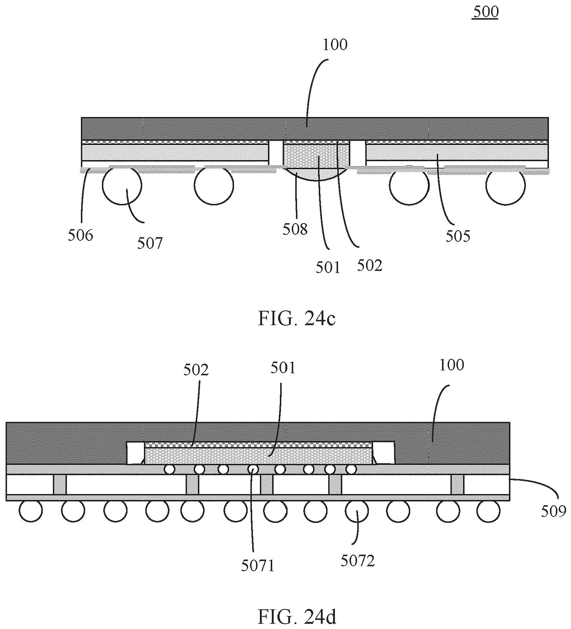

Refer to FIG. 24a, FIG. 24b, FIG. 24c, and FIG. 24d. An embodiment of this application further provides a semiconductor structure 500. The semiconductor structure 500 includes a semiconductor chip 501 and the foregoing carbon material 100 in this embodiment of this application. The carbon material 100 covers the semiconductor chip 501, and the carbon material 100 is configured to dissipate and equalize heat for the semiconductor chip 501. The carbon material 100 may partially or completely cover the semiconductor chip 501. In this embodiment of this application, the carbon material has good heat conduction performance and a low coefficient of thermal expansion. This helps reduce thermal stress inside the semiconductor chip 501. In addition, the carbon material has a light weight, which helps reduce a weight of the semiconductor structure. In this application, a specific structure design of the semiconductor structure 500 is not limited, and may be in various structure forms, for example, may be in the structure forms shown in FIG. 24a, FIG. 24b, FIG. 24c, and FIG. 24d. Refer to FIG. 24a. The carbon material 100 may directly replace the conventional heat-conductive metal sheet, and be combined with the semiconductor chip 501 by using a thermal interface layer 502. Refer to FIG. 24b. The carbon material 100 may also be attached to a heat-conductive metal sheet 503, and then be combined with the semiconductor chip 501 by using the thermal interface layer 502, that is, the carbon material 100 is combined with the heat-conductive metal sheet 503. The thermal interface layer 502 may be made of an organic or inorganic material. The semiconductor chip 501 may be various functional chips, and the semiconductor structure may also include a plurality of semiconductor chips 501. The semiconductor structure 500 may be specifically a semiconductor packaging structure. The semiconductor structure 500 may further include a packaging body 504 for packaging the semiconductor chip 501. As shown in FIG. 24a and FIG. 24b, a part of the carbon material 100 is packaged inside the packaging body 504, and a surface of one side of the carbon material 100 is exposed to the outside of the packaging body 504. The packaging body 504 may be various materials that may be used for semiconductor packaging. For example, the packaging body 504 may be a plastic packaging body. Refer to FIG. 24c. In some embodiments, the semiconductor structure 500 further includes a metal layer 505 stacked with the carbon material 100 by using the thermal interface layer 502, a ground layer 506 stacked with the metal layer 505, a solder ball 507 configured to connect to the circuit board, and a sealing layer 508 configured to protect the semiconductor chip 501. Refer to FIG. 24d. In some embodiments, the semiconductor packaging structure further includes a circuit board 509, a solder ball 5071, and a solder ball 5072. The semiconductor chip 501 is connected to the circuit board 509 by using the solder ball 5071, and the solder ball 5072 is configured to connect to another circuit board.

In this application, "to" between two values indicates a range including the two endpoint values. For example, 40 MPa to 80 MPa includes endpoint values 40 MPa and 80 MPa, and any value between the two endpoint values.

Embodiments of this application are further described below by using a plurality of embodiments.

### Embodiment 1 to Embodiment 5

Large-diameter graphite oxide is produced through low-temperature processing. A specific mass of flake graphite with a diameter of about 200 nm is prepared based on weighing. 0.1 g/ml potassium permanganate and 95 wt% concentrated sulphuric acid are added dropwise. An oxidation reaction temperature is controlled to be 25°C. A reaction time is 4 hours. After washing the graphite oxide on which oxidation reaction is performed, a large-diameter graphite oxide solution is obtained, where a size D₅₀ of the obtained large-diameter graphite oxide is greater than 100 µm, and an oxygen content of the graphite oxide is about 35%. The size D₅₀ of the graphite oxide is obtained through detection by using a laser particle size analyzer, and the oxygen content of the graphite oxide may be obtained by using an EA (Elemental Analyzer, elemental analyzer).

The graphite oxide produced through low-temperature processing is dispersed in a solution of water and ethanol, and a catalyst is added, to produce a graphite oxide slurry with a 2% solid content. An ethanol mass proportion in the graphite oxide slurry is shown in Table 1. Blade coating of the obtained graphite oxide slurry is performed on a polymer substrate woven by using fibers for formation. Then, a graphite oxide film is baked at 120°C, and a heating rate in a baking process is shown in Table 1. After baking is completed, preliminary thermal reduction is performed in an inert atmosphere. A reduction temperature is 350°C, a heating rate is 5°C/min, and a soaking time is 4 hours. After preliminary thermal reduction, high-temperature graphitization is performed at 3100°C, to obtain a porous and highly oriented carbon film. Then high-temperature and high-pressure calendering is performed under a pressure of 70 MPa to form a film. Finally, a finished carbon film is obtained.

Surface density of wrinkles, elongation at break, and thermal diffusivity of the obtained carbon film are characterized, and results are shown in Table 1. The surface density of wrinkles can be characterized by using a scanning electron microscope.

**Table 1 Processing parameters and carbon material characterization results**

| | Embodiment 1 | Embodiment 2 | Embodiment 3 | Embodiment 4 | Embodiment 5 |
|---|---|---|---|---|---|
| Ethanol mass fraction | 30% | 50% | 60% | 50% | 50% |
| Heating rate (°C/min) | 10 | 10 | 10 | 15 | 20 |
| Surface density of wrinkles (µm/µm²) | 153 | 235 | 284 | 294 | 357 |
| Elongation at break (%) | 5.8% | 6.6% | 7.5% | 7.6% | 8.4% |
| In-plane thermal diffusivity (mm²/s) | 752 | 733 | 721 | 689 | 657 |

It can be leant from the results of Table 1 that, increase in the ethanol content which rapidly evaporates helps obtain higher surface density of wrinkles on the carbon material, so that higher elongation at break can be obtained. In the baking process, rise of the heating rate helps formation of the wrinkle structures, so that the surface density of wrinkles on the carbon material can be higher. In this way, higher elongation at break can be obtained. In addition, in embodiments of this application, the surface density of wrinkles is adjusted to an appropriate range, so that the carbon material has high elongation at break and thermal diffusivity, and the carbon material is bending-resistant and has good heat conduction performance.

### Embodiment 6 to Embodiment 10

The graphite oxide produced through low-temperature processing in Embodiment 1 is dispersed in a solution of water and ethanol, and a catalyst is added, to produce a graphite oxide slurry with a 2% solid content. Amass fraction of the ethanol is 50%. Blade coating of the graphite oxide slurry is performed on a polymer substrate woven by using fibers for formation. Then, a graphite oxide film is baked at 120°C, and a heating rate is 15°C/min. After baking is completed, preliminary thermal reduction is performed in an inert atmosphere. A reduction temperature is 350°C, a heating rate is 5°C/min, and a soaking time is 4 hours. Then a prefabricated carbon film, that is, a carbon material precursor is obtained. The prefabricated carbon film is placed on a biaxial drawing device for wrinkle processing. Table 2 shows a strain of a squeezing operation in wrinkle processing. After wrinkle processing, high-temperature graphitization is performed at 3100°C, to obtain a bendable carbon film that is porous and highly oriented. Then high-temperature and high-pressure calendering is performed under a pressure of 70 MPa to form a film. Finally, a finished carbon film is obtained.

Surface density of wrinkles, elongation at break, and thermal diffusivity of the carbon film are characterized, and results are shown in Table 2.

**Table 2 Processing parameters and carbon material characterization results**

| | Embodiment 6 | Embodiment 7 | Embodiment 8 | Embodiment 9 | Embodiment 10 |
|---|---|---|---|---|---|
| Squeezing strain (%) | 10 | 20 | 30 | 50 | 80 |
| Surface density of wrinkles (µm/µm²) | 266 | 293 | 325 | 384 | 456 |
| Elongation at break (%) | 7.1 | 7.6 | 8.2 | 8.9 | 10.5 |
| In-plane thermal diffusivity (mm²/s) | 705 | 688 | 656 | 648 | 612 |

It can be learned from the results in Table 2 that, increase in the strain of the squeezing operation in wrinkle processing helps obtain higher surface density of wrinkles on the carbon material. In this case, higher elongation at break can be obtained. In addition, in embodiments of this application, the surface density of wrinkles is adjusted to an appropriate range, so that the carbon material has high elongation at break and thermal diffusivity.

## Claims

1. A carbon material, wherein elongation at break of the carbon material in at least one direction is greater than or equal to 5%, in-plane thermal diffusivity of the carbon material is greater than or equal to 500 mm²/s, a surface of the carbon material has a plurality of wrinkle structures, and a total length of the wrinkle structures in a unit area of 1 µm² on the surface of the carbon material is within a range of 1 µm to 500 µm.

2. The carbon material according to claim 1, wherein the plurality of wrinkle structures comprise a plurality of macro wrinkle structures having millimeter-level lengths and/or a plurality of micro wrinkle structures having micron-level or submicron-level lengths.

3. The carbon material according to claim 2, wherein the plurality of macro wrinkle structures follow an orientation distribution on the surface of the carbon material, and the plurality of micro wrinkle structures follow an irregular distribution on the surface of the carbon material.

4. The carbon material according to any one of claims 1 to 3, wherein average surface roughness Ra of the carbon material is greater than 100 nm.

5. The carbon material according to any one of claims 1 to 4, wherein the carbon material has a pristine film feature when a thickness is less than or equal to 5 mm.

6. The carbon material according to any one of claims 1 to 5, wherein the carbon material comprises a plurality of stacked carbon atom layers, and in the carbon material, a turbostratic stack proportion of the plurality of stacked carbon atom layers is greater than or equal to 10%.

7. The carbon material according to any one of claims 1 to 6, wherein a crystallographic L_{c} size of a crystal grain of the carbon material is greater than or equal to 50 nm.

8. The carbon material according to any one of claims 1 to 7, wherein a crystallographic Lₐ size of the crystal grain of the carbon material is greater than or equal to 10 µm.

9. The carbon material according to any one of claims 1 to 8, wherein a C=C proportion of the carbon material is greater than or equal to 80%.

10. The carbon material according to any one of claims 1 to 9, wherein a layer spacing between the plurality of stacked carbon atom layers is greater than or equal to 0.3 nm and less than or equal to 0.5 nm.

11. The carbon material according to any one of claims 1 to 10, wherein a breaking strength of the carbon material is greater than or equal to 30 MPa.

12. The carbon material according to any one of claims 1 to 11, wherein the carbon material comprises a carbon film, a carbon sheet, or a carbon plate.

13. The carbon material according to any one of claims 1 to 12, wherein the carbon material is obtained by graphitizing graphite oxide.

14. The carbon material according to claim 13, wherein in a process of producing the carbon material by using the graphite oxide, a volatile solvent is added to a graphite oxide solution, and the volatile solvent is evaporated to form the wrinkle structures; and/or a non-graphitized carbon material precursor is repeatedly squeezed and stretched in a first axial direction and/or a second axial direction to form the wrinkle structures, wherein the first axial direction and the second axial direction are perpendicular to each other.

15. A heat dissipation assembly, wherein the heat dissipation assembly comprises the carbon material according to any one of claims 1 to 14.

16. The heat dissipation assembly according to claim 15, wherein the heat dissipation assembly further comprises a heat dissipation element that is attached to a surface of the carbon material or that is embedded in the carbon material.

17. The heat dissipation assembly according to claim 15, wherein the heat dissipation assembly comprises a base and a heat dissipation fin disposed on the base, and the carbon material is used in the base and/or the heat dissipation fin.

18. The heat dissipation assembly according to claim 17, wherein the heat dissipation assembly further comprises a heat pipe and/or a vapor chamber connected to the base and the heat dissipation fin.

19. An electronic device, wherein the electronic device comprises the carbon material according to any one of claims 1 to 14 or the heat dissipation assembly according to any one of claims 15 to 18.

20. The electronic device according to claim 19, wherein the electronic device comprises a display, a middle frame, a rear cover, and a circuit board, the middle frame is configured to carry the display and the circuit board, the middle frame is located between the display and the rear cover, and the carbon material is disposed between the middle frame and the rear cover and/or between the middle frame and the display.

21. The electronic device according to claim 19 or 20, wherein the electronic device further comprises a two-phase liquid cooling heat dissipation member, and the two-phase liquid cooling heat dissipation member is fixedly connected to a surface of the carbon material, or the two-phase liquid cooling heat dissipation member is partially or completely embedded in the carbon material.

22. The electronic device according to claim 21, wherein the two-phase liquid cooling heat dissipation member comprises a heat pipe and/or a vapor chamber.

23. The electronic device according to claim 19, wherein the electronic device comprises a bendable heating element, and the carbon material is disposed on the heating element.

24. A battery system, wherein the battery system comprises the carbon material according to any one of claims 1 to 14.

25. The battery system according to claim 24, wherein the battery system comprises a plurality of battery packs, each of the battery packs comprises a plurality of single cells connected in series, and the carbon material is disposed between the plurality of battery packs and/or between the plurality of single cells connected in series.

26. A semiconductor structure, wherein the semiconductor structure comprises a semiconductor chip and a carbon material covering the semiconductor chip, and the carbon material comprises the carbon material according to any one of claims 1 to 14.
